(19) Europäisches Patentamt / European Patent Office / Office européen des brevets

(11) **EP 4 216 681 B1**

(12) **EUROPEAN PATENT SPECIFICATION**

(45) Date of publication and mention
of the grant of the patent:
**22.04.2026 Bulletin 2026/17**

(21) Application number: **21895007.9**

(22) Date of filing: **11.11.2021**

(51) International Patent Classification (IPC):
*H05K 1/02* (2006.01)   *H04M 1/02* (2006.01)
*H01P 3/08* (2006.01)   *H01P 5/02* (2006.01)
*H01P 3/02* (2006.01)   *H05K 1/03* (2006.01)
*H05K 1/14* (2006.01)

(52) Cooperative Patent Classification (CPC):
**H04M 1/0277; H01P 3/026; H05K 1/0224;**
**H05K 1/0245;** H05K 1/0228; H05K 1/0253;
H05K 1/0393; H05K 1/147; H05K 2201/0715;
H05K 2201/09236; H05K 2201/093;
H05K 2201/09681

(86) International application number:
**PCT/KR2021/016407**

(87) International publication number:
**WO 2022/108237 (27.05.2022 Gazette 2022/21)**

(54) **ELECTRONIC DEVICE COMPRISING FLEXIBLE PRINTED CIRCUIT BOARD**

ELEKTRONISCHE VORRICHTUNG MIT FLEXIBLER LEITERPLATTE

DISPOSITIF ÉLECTRONIQUE COMPRENANT UNE CARTE DE CIRCUIT IMPRIMÉ SOUPLE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **17.11.2020 KR 20200153762**

(43) Date of publication of application:
**26.07.2023 Bulletin 2023/30**

(73) Proprietor: **Samsung Electronics Co., Ltd.**
**Suwon-si, Gyeonggi-do 16677 (KR)**

(72) Inventors:
• **BAEK, Woosheok**
  **Suwon-si, Gyeonggi-do 16677 (KR)**
• **KIM, Seungjoon**
  **Suwon-si, Gyeonggi-do 16677 (KR)**

• **VIN, Youngboo**
  **Suwon-si, Gyeonggi-do 16677 (KR)**
• **CHUNG, Ilhyung**
  **Suwon-si, Gyeonggi-do 16677 (KR)**
• **CHOI, Dongmin**
  **Suwon-si, Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(56) References cited:
KR-A- 20190 013 804    KR-A- 20190 013 804
KR-A- 20190 092 211    KR-A- 20190 101 545
US-A1- 2001 010 271    US-A1- 2001 010 271
US-A1- 2010 327 989    US-A1- 2011 030 997
US-A1- 2014 203 417

**Description**

[Technical Field]

Embodiments disclosed in the disclosure relate to an electronic device including a flexible printed circuit board.

[Background Art]

Electronic parts of an electronic device, such as a display and a camera, may be connected to a main circuit board, through a flexible printed circuit board. As the kinds and the number of the electronic parts disposed in the electronic device increase, a high flexibility is required for the flexible printed circuit board to improve a mounting performance of the electronic parts and a spatial utility of an interior of the electronic device. To increase the flexibility of the flexible printed circuit board, a mesh ground including a conductive pattern in a form of a mesh may be used.

Meanwhile, the flexible printed circuit board connected to the electronic components may include differential lines. The differential lines widely used for an interface of high-speed processing hardware transmit signals having opposite polarities by using a pair of transmission lines to decrease interferences of the signals.

US 2001/0010271 A1 discloses a flexible circuit board. US 2010/0327989 A1 discloses micro-strip transmission lines.

[Disclosure]

[Technical Problem]

When the flexible printed circuit board includes a mesh ground instead of a plane ground, an area for grounding may decrease, and a quality of the signals transmitted through the differential lines may be degraded due to a discontinuity of a conductive pattern of the mesh ground.

Furthermore, when the flexible printed circuit board includes a plurality of differential lines, cross-talks may occur between the differential lines. To improve the cross-talks between the differential lines, a measure of adding guard traces between the differential lines may be applied. However, the measure of adding the guard traces may further degrade the quality of the signals because a reference voltage is shaken when the guard traces are insufficiently connected to a ground. Furthermore, because the guard traces have to be additionally disposed, an entire width of the flexible printed circuit board may increase. Because the width of the flexible printed circuit board increases, the volume thereof may increase and the flexibility thereof may be degraded whereby the space utility of the electronic device may be degraded. When the guard traces are omitted to decrease the width of the flexible printed circuit board, more cross-talks may occur between the differential lines.

[Technical Solution]

The present invention is set out in the appended claim set.

A flexible printed circuit board according to an embodiment disclosed in the disclosure may include a first dielectric layer, a first differential line including a first transmission line, and a second transmission line that is substantially parallel to the first transmission line, and a first mesh ground disposed on a second surface of the first dielectric layer, and the first transmission line may include first stubs disposed at a first distance along a lengthwise direction of the first transmission line, and protruding in a first direction that is substantially perpendicular to a lengthwise direction of the first transmission line, and second stubs disposed at a second distance along the lengthwise direction of the first transmission line, and protruding in a second direction that is opposite to the first direction - each of the second stubs protrudes toward the second transmission line between the adjacent first stubs, and the second transmission line may include third stubs disposed at the first distance along a lengthwise direction of the second transmission line and protruding in the first direction - each of the third stubs are at least partially aligned with the corresponding first stub in the first direction, and fourth stubs disposed at the second distance along a lengthwise direction of the second transmission line and protruding in the second direction - each of the fourth stubs are at least partially aligned with the corresponding second stub in the second direction.

An electronic device according to an embodiment may include a plurality of flexible printed circuit boards, a first printed circuit board, a camera module electrically connected to the first printed circuit board through, among the plurality of flexible printed circuit boards, a first flexible printed circuit board, and a second printed circuit board electrically connected to the first printed circuit board through, among the plurality of flexible printed circuit boards, a second flexible printed circuit board, each of the plurality of flexible printed circuit boards may include a first dielectric layer, a first differential line disposed on a first surface of the first dielectric layer, and including a first transmission line and a second transmission line that is substantially parallel to the first transmission line, and a mesh ground disposed on a second surface of the first dielectric layer, the first transmission line may include first stubs disposed at a first distance along a lengthwise direction of the first transmission line, and protruding in a first direction that is substantially perpendicular to a lengthwise direction of the first transmission line, and second stubs disposed at a second distance along the lengthwise direction of the first transmission line, and protruding in a second direction that is opposite to the first direction - each of the second stubs protrudes toward the second transmission line between the adjacent first stubs, and the second transmission line may include third stubs disposed at the first distance along a lengthwise direction of the second transmission line and protruding in the first direction - each of the third stubs are at least partially aligned with the corresponding first stub in the first direction, and fourth stubs disposed at the first distance along a lengthwise direction of the second transmission line and protruding in the second direction - each of the fourth stubs are at least partially aligned with the corresponding second stub in the second direction.

[Advantageous Effects]

According to the embodiments disclosed in the disclosure, the cross-talks between the differential lines of the flexible printed circuit board may be reduced.

According to the embodiments disclosed in the disclosure, a quality of signals transmitted through the differential lines may be enhanced while the flexibility of the flexible printed circuit board is enhanced.

In addition, various effects that are directly or indirectly recognized through the disclosure may be provided.

[Description of Drawings]

FIG. 1 is an exploded perspective view of a front surface of a mobile electronic device according to an embodiment.
FIG. 2 is a perspective view of a rear surface of the electronic device of FIG. 1.
FIG. 3 is an exploded perspective view of the electronic device of FIG. 1.
FIG. 4 illustrates an interior of an electronic device according to an embodiment.
FIG. 5 illustrates a cross-section of a flexible printed circuit board according to an embodiment.
FIG. 6A is a plan view of a flexible printed circuit board according to an embodiment.
FIG. 6B illustrates a first differential line according to an embodiment.
FIG. 6C is a plan view of a flexible printed circuit board, which illustrates a mesh ground, according to another embodiment.
FIG. 7 is an equivalent circuit diagram of the first differential line and a second differential line of FIG. 6A.
FIG. 8A is a graph depicting voltages of far-end cross-talks of a differential line according a comparative example and a differential line according to an embodiment.
FIG. 8B is a graph depicting "S" parameters of a flexible printed circuit board according to a comparative example and a flexible printed circuit board according to an embodiment.
FIG. 8C illustrates voltages of a flexible printed circuit board according to a comparative example and a flexible printed circuit board according to an embodiment.
FIG. 9 is a block diagram of an electronic device 901 in a network environment 900 according to various embodiments.

In relation to a description of the drawings, the same or similar reference numerals may be used for the same or similar components.

[Mode for Invention]

Hereinafter, various embodiments of the disclosure will be described with reference to the accompanying drawings. However, it should be understood that the disclosure is not limited to specific embodiments and the disclosure includes various modifications, equivalents, and/or alternatives of the embodiments.

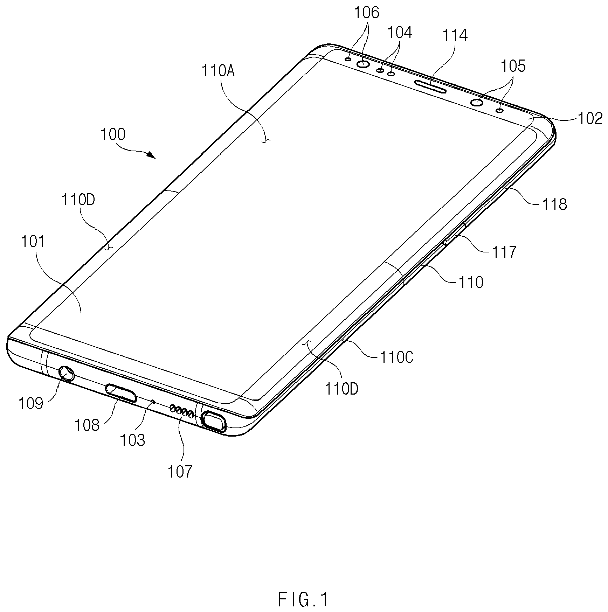

FIG. 1 is an exploded perspective view of a front surface of a mobile electronic device according to an embodiment.

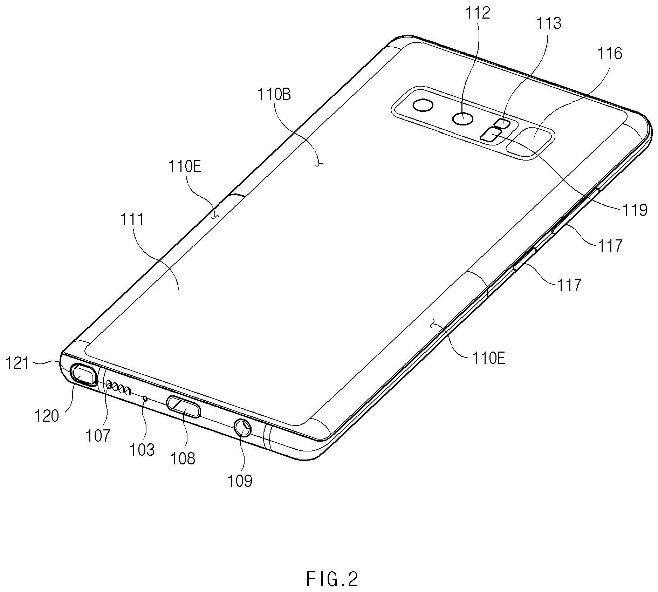

FIG. 2 is a perspective view of a rear surface of the electronic device of FIG. 1.

Referring to FIGS. 1 and 2, an electronic device 100 according to an embodiment may include a housing 110. In an embodiment, the housing 110 may include a first surface (or a front surface) 110A, a second surface (or a rear surface) 110B, and a side surface 110C that surrounds a space between the first surface 110A and the second surface 110B. In another embodiment, the housing 110 may refer to a structure that defines a portion of the first surface 110A, the second surface 110B, and/or the side surface 110C of FIG. 1. According to an embodiment, at least a portion of the first surface 110A may be formed by a substantially transparent front plate 102 (e.g., a glass plate including various coating layers or a polymer plate). The second surface 110B may be formed by a substantially opaque rear plate 111. The rear plate 111, for example, may be formed of coated or colored glass, a polymer, a metal (e.g., aluminum, stainless steel (STS), or magnesium), or a combination of at least two of the materials. The side surface 110C may be defined by a side bezel structure (or a "side member") 118 coupled to the front plate 102 and the rear plate 111 and including a metal and/or a polymer. In some embodiments, the rear plate 111 and the side bezel structure 118 may be integrally formed, and may include the same material (e.g., a metallic material such as aluminum).

In the illustrated embodiment, the front plate 102 may include two first areas 110D that are bent from the first surface 110A toward the rear plate 111 and extend seamlessly at opposite ends of a long edge of the front plate 102. In the illustrated embodiment (see FIG. 2), the rear plate 111 may include two second areas 110E that are bent from the second surface 110B toward the front plate 102 and extend seamlessly at opposite ends of a long edge thereof. In some embodiments, the front plate 102 (or the rear plate 111) may include only one of the first areas 110D (or the second areas 110E). In another embodiment, some of the first areas 110D or the second areas 110E may not be included. In the embodiments, when viewed from a lateral side of the electronic device 100, the side bezel structure 118 may have a first thickness (or width) on a side, on which neither the first areas 110D nor the second areas 110E are included, and may have a second thickness that is smaller than the first thickness on a side, on which the first areas 110D or the second areas 110E are included.

According to an embodiment, the electronic device 100 may include at least one of a display 101, audio modules 103, 107, and 104, sensor modules 104, 116, and 119, camera modules 105, 112, and 113, a key input device 117, a light emitting element 106, a pen input device 120, and connector holes 108 and 109. In some embodiments, at least one (e.g., the key input device 117 or the light emitting element 106) of the components may be omitted or another component may be additionally included in the electronic device 100.

The display 101, for example, may be exposed through a considerable part of the front plate 102. For example, the display 101 may be viewed (or visually exposed) through the considerable part of the front plate 102. In some embodiments, at least a portion of the display 101 may be exposed through the first surface 110A, and the front plate 102 that defines the first area 110D of the side surface 110C. In some embodiments, a shape of a corner of the display 101 may be formed to be substantially the same as an adjacent outskirt shape of the front plate 102. In another embodiment (not illustrated), to expand an exposure area of the display 101, a distance between an outskirt of the display 101 and an outskirt of the front plate 102 may be formed to be substantially the same.

In another embodiment (not illustrated), a recess or an opening may be formed at a portion of a screen display area of the display 101, and at least one of the audio module 114, the sensor module 104, the camera module 105, and the light emitting element 106 may be aligned with the recess or the opening. In another embodiment (not illustrated), at least one of the audio module 114, the sensor module 104, the camera module 105, the fingerprint sensor 116, and the light emitting element 106 may be included on a rear surface of the screen display area of the display 101. In another embodiment (not illustrated), the display 101 may be coupled to or disposed adjacent to a pressure sensor that may measure an intensity (pressure) of a touch detecting circuit and/or a digitizer that detects a stylus pen of a magnetic scheme. In some embodiments, at least a portion of the sensor module 104 and 119 and/or at least a portion of the key input device 117 may be disposed in the first area 110D and/or the second area 110E.

The audio modules 103, 107, and 114 may include the microphone hole 103 and the speaker holes 107 and 114. A microphone for acquiring an external sound may be disposed in the microphone hole 103, and in some embodiments, a plurality of microphones may be disposed to detect a direction of the sound. The speaker holes 107 and 114 may include the external speaker hole 107 and the communication receiver hole 114. In some embodiments, the speaker holes 107 and 114 and the microphone hole 103 may be implemented by one hole, or the speaker may include no speaker hole 107 and 114 (e.g., a piezoelectric speaker).

The sensor modules 104, 116, and 119 may generate electrical signals or data values corresponding to an operation state of an interior of the electronic device 100 or an external environment state. The sensor modules 104, 116, and 119, for example, may include the first sensor module 104 (e.g., a proximity sensor) and/or a second sensor module (not illustrated) (e.g., a fingerprint sensor) disposed on the first surface 110A of the housing 110, and/or the third sensor module 119 (e.g., an HRM sensor) and/or the fourth sensor module 116 (e.g., a fingerprint sensor) disposed on the second surface 110B of the housing 110. The fingerprint sensor may be disposed on not only the first surface 110A (e.g., the display 101) but also the second surface 110B of the housing 110. The electronic device 100 may further include sensor modules that are not illustrated, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illumination intensity sensor.

The camera modules 105, 112, and 113 may include the first camera device 105 disposed on the first surface 110A of the electronic device 100, and the second camera device 112 and/or the flash 113 disposed on the second surface 110B. The camera devices 105 and 112 may include one or a plurality of lenses, an image sensor, and/or an image signal processor. The flash 113, for example, may include a light emitting diode or a xenon lamp. In some embodiments, two or more lenses (an infrared ray camera, a wide-angle and telescopic lens) and image sensors may be disposed on one surface of the electronic device 100.

The key input device 117 may be disposed on the side surface 110C of the housing 110. In another embodiment, the electronic device 100 may not include some or all of the above-mentioned key input devices 117, and the key input device(s) that is not included may be implemented in another form, such as a soft key, on the display 101. In some embodiments, the key input device may include the sensor module 116 disposed on the second surface 110B of the housing 110.

The light emitting element 106, for example, may be disposed on the first surface 110A of the housing 110. The light emitting element 106 may provide state information of the electronic device 100 in a form of light. In another embodiment, the light emitting element 106, for example, may provide a light source that is operated in association with an operation of the camera module 105. The light emitting element 106, for example, may include an LED, an IR LED, and a xenon lamp.

The connector holes 108 and 109 may include the first connector hole 108 that may accommodate a connector (for example, a USB connector) for transmitting and receiving power and/or data to and from an external electronic device, and/or the second connector hole (for example, an earphone jack) 109 that may accommodate a connector for transmitting and receiving an audio signal to and from the external electronic device.

The pen input device 120 (e.g., a stylus pen) may be guided into an interior of the housing 110 through a hole formed on a side surface of the housing 110 to be inserted thereinto or attached thereto, and a button for facilitate attachment and detachment thereof may be included. The pen input device 120 may have a separate resonance circuit therein, and may be operated in association with an electromagnetic induction panel 390 (e.g., a digitizer) included in the electronic device 100. The pen input device 120 may employ an electro-magnetic resonance (EMR) scheme, an active electrical stylus (AES) scheme, and an electric coupled resonance (ECR) scheme.

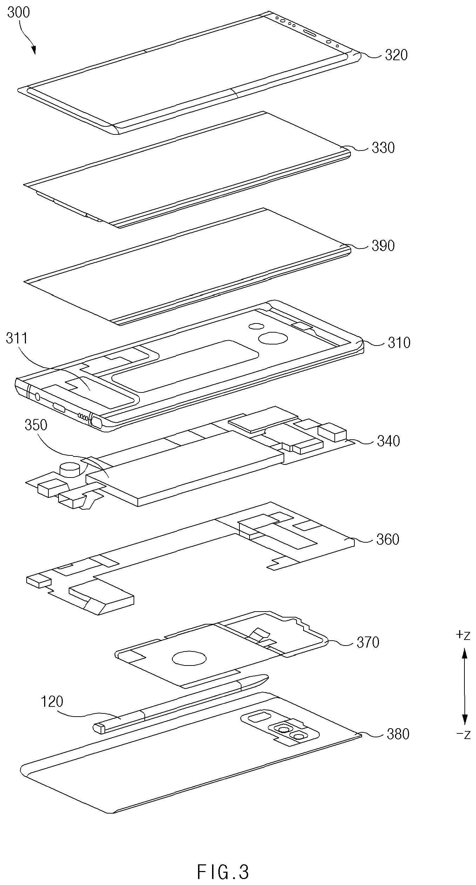

FIG. 3 is an exploded perspective view of the electronic device of FIG. 1.

Referring to FIG. 3, an electronic device 300 (e.g., the electronic device 100 of FIG. 1) may include a side bezel structure 310 (e.g., the side bezel structure 118 of FIG. 1), a first support member 311 (e.g., a bracket), a front plate 320 (e.g., the front plate 101 of FIG. 1), a display 330 (e.g., the display 102 of FIG. 1), the electromagnetic induction panel 390, a printed circuit board 340, a battery 350, a second support member 360 (e.g., a rear case), an antenna 370, the pen input device 120, and a rear plate 380 (e.g., the rear plate 111 of FIG. 2). In some embodiments, at least one (e.g., the first support member 311 or the second support member 360) of the components may be omitted or another component may be additionally included in the electronic device 300. At least one of the components of the electronic device 300 may be the same as or similar to at least one of the components of the electronic device 100 of FIG. 1 or FIG. 2, and a repeated description thereof will be omitted below.

The electromagnetic induction panel 390 (e.g., the digitizer) may be a panel for detecting an input of the pen input device 120. For example, the electromagnetic induction panel 390 may include a printed circuit board (PCB) (e.g., a flexible printed circuit board (FPCB)) and a shield sheet. The shield sheet may prevent mutual interferences of the components (e.g., the display module, the printed circuit board, and/or the electromagnetic induction panel) included in the electronic device 300 by electromagnetic fields generated by the components. The shield sheet may allow the input from the pen input device 120 to be accurately delivered to a coil included in the electromagnetic induction panel 390 by shielding electromagnetic fields generated by the components. The electromagnetic induction panel 390 according to various embodiments may include an opening formed on at least a partial area corresponding to a biometric sensor disposed in the electronic device 300.

The first support member 311 may be disposed in an interior of the electronic device 300 to be connected to the side bezel structure 310 or to be integrally formed with the side bezel structure 310. The first support member 311, for example, may include a metallic material and/or a nonmetallic material (e.g., a polymer). The display 330 may be coupled to one surface of the first support member 311, and the printed circuit board 340 may be coupled to an opposite surface thereof. A processor, a memory, and/or an interface may be mounted on the printed circuit board 340. The processor, for example, may include one or more of a central processing unit, an application processor, a graphic processing unit, an image signal processor, a sensor hub processor, or a communication processor.

The memory, for example, may include a volatile memory or a nonvolatile memory.

The interface, for example, may include a high definition multimedia interface (HDMI), a universal serial bus (USB) interface, an SD card interface, and/or an audio interface. The interface, for example, may be electrically or physically connect the electronic device 300 to an external electronic device, and may include a USB connector, an SD card/MMC connector, or an audio connector.

The battery 350 is a device for supplying electric power to at least one component of the electronic device 300, and for example, may include a primary battery that cannot be recharged, a rechargeable secondary battery, or a fuel battery. At least a portion of the battery 350, for example, may be disposed on substantially the same plane as that of the printed circuit board 340. The battery 350 may be disposed integrally in an interior of the electronic device 300, and may be disposed to be attached or detached from the electronic device 300.

**EP 4 216 681 B1**

The antenna 370 may be disposed between the rear plate 380 and the battery 350. The antenna 370, for example, may include a near field communication (NFC) antenna, a wireless charging antenna, and/or a magnetic secure transmission (MST) antenna. The antenna 370, for example, may perform short-range communication with an external device or may wirelessly transmit and receive electric power that is necessary for charging. In another embodiment, an antenna structure may be formed by the side bezel structure 310 and/or the first support member 311 or a combination thereof.

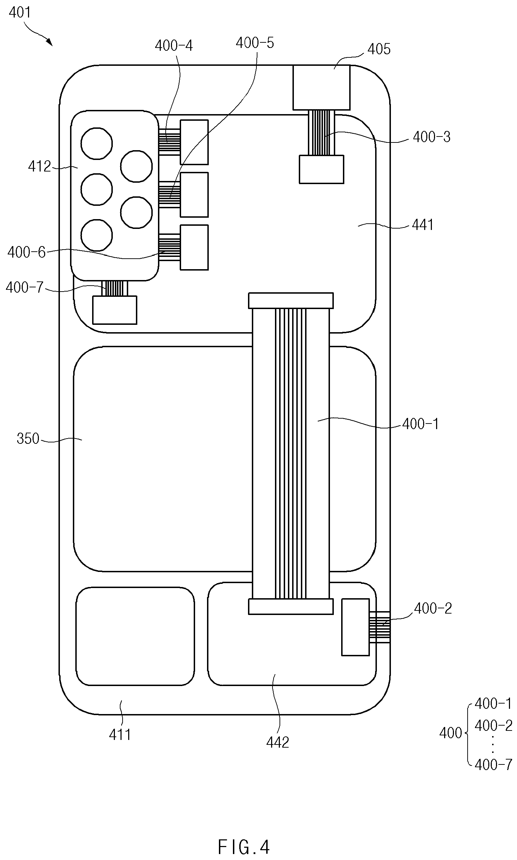

FIG. 4 illustrates the interior of the electronic device according to an embodiment.

Referring to FIG. 4, an electronic device 401 (e.g., the electronic device 300 of FIG. 3) according to an embodiment may include a support member 411, a flexible printed circuit board 400, a first printed circuit board 441, a second printed circuit board 442, a first camera module 405, a second camera module 412, and the battery 350.

In an embodiment, the support member 411 may support various parts of the electronic device 401. In an embodiment, the support member 411 may define a space, in which various parts of the electronic device 401 of the electronic device 401 are accommodated. In an embodiment, the support member 411 may correspond to the side bezel structure 310 and/or the first support member 311 of FIG. 3.

In an embodiment, the flexible printed circuit board 400 may include first to seventh flexible printed circuit boards 400-1 to 400-7. In an embodiment, the flexible printed circuit board 400 may connect the electronic parts of the electronic device 401. For example, the first flexible printed circuit board 400-1 may electrically connect the first printed circuit board 441 and the second printed circuit board 442. Through the first printed circuit board 441 and the second printed circuit board 442 electrically connected to each other by the first flexible printed circuit board 400-1, various parts disposed therein or electrically connected thereto may be operatively connected to each other. As another example, the second flexible printed circuit board 400-2 may electrically connect the second printed circuit board 442 and the display (not illustrated) (e.g., the display 330 of FIG. 3) of the electronic device 401. As another example, the third flexible printed circuit board 400-3 may electrically connect the first printed circuit board 441 and the first camera module 405. As another example, the fourth to seventh flexible printed circuit boards 400-4 to 400-7 may electrically connect the second camera module 412 and the first printed circuit board 441.

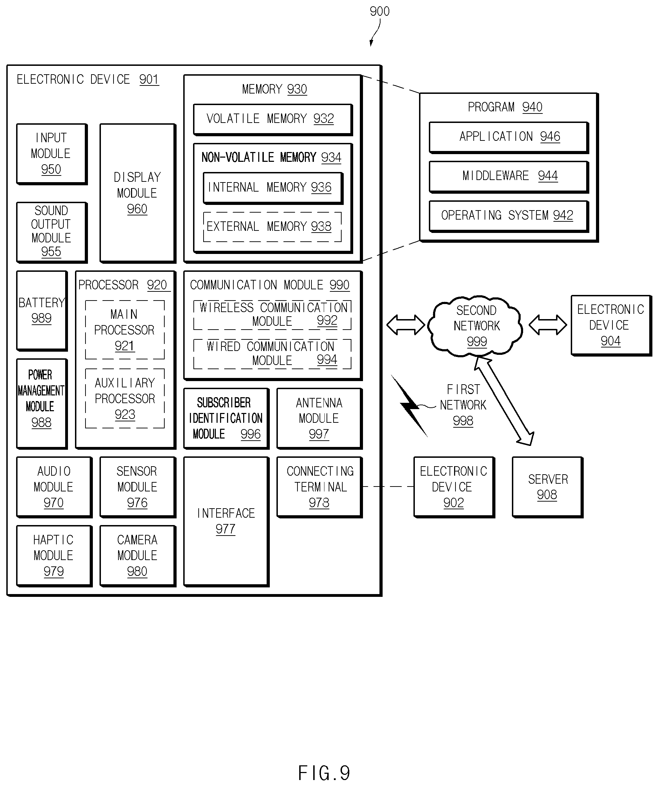

In an embodiment, the first printed circuit board 441 and the second printed circuit board 442 may be disposed on the support member 411. Various parts of the electronic device 401 may be disposed in the first printed circuit board 441 and the second printed circuit board 442. For example, a processor (e.g., a processor 920 of FIG. 9) and/or a memory (e.g., a memory 930 of FIG. 9) may be disposed in the first printed circuit board 441 and/or the second printed circuit board 442, but the disclosure is not limited to the above-described example. As another example, at least one of the components of FIG. 9 may be disposed in the first printed circuit board 441 and the second printed circuit board 442.

In an embodiment, the first camera module 405 may be disposed on the support member 411. In an embodiment, the first camera module 405 may include at least one camera including a plurality of lenses. In an embodiment, the first camera module 405 may be disposed such that the at least one camera faces a front surface (e.g., the front surface 110A of FIG. 1) of the electronic device 401. In an embodiment, the first camera module 405 may be electrically connected to the first printed circuit board 441 through the third flexible printed circuit board 400-3, and may be electrically connected to a processor (e.g., the processor 920 of FIG. 9) for controlling the first camera module 405 through an electrical path (e.g., a conductive trace) formed in the first printed circuit board 441. The processor according to an embodiment may communicate with the first camera module 405 through a specific interface (for example, a mobile industry processor interface (MIPI)) (however, the disclosure is not limited thereto). In an embodiment, through the third flexible printed circuit board 400-3 connected to the first camera module 405, an electrical signal including a control signal related to the first camera module 405 and/or image data acquired by the first camera module 405 may be transmitted.

In an embodiment, the second camera module 412 may include a plurality of cameras. In an embodiment, the second camera module 412 may be disposed such that the plurality of cameras face a rear surface (e.g., the rear surface 110B of FIG. 2) of the electronic device 401. In an embodiment, the second camera module 412 may acquire image data corresponding to a direction that faces the rear surface by using the plurality of cameras. In an embodiment, the second camera module 412 may be electrically connected to the first printed circuit board 441 through the fourth to seventh flexible printed circuit boards 400-4 to 400-7, and may be electrically connected to a processor for controlling the second camera module 412 through by a medium of the first printed circuit board 441. The processor according to an embodiment may communicate with the second camera module 412 through a specific interface (for example, a MIPI)) (however, the disclosure is not limited thereto). In an embodiment, an electrical signal for controlling the second camera module 412 and/or an electrical signal including image data acquired through the second camera module 412 may be transmitted through at least one of the fourth to seventh flexible printed circuit boards 400-4 to 400-7.

In an embodiment, the battery 350 may be disposed on the support member 411 and may be supported by the support member 411. In an embodiment, the battery 350 may be disposed between the first printed circuit board 441 and the second printed circuit board 442.

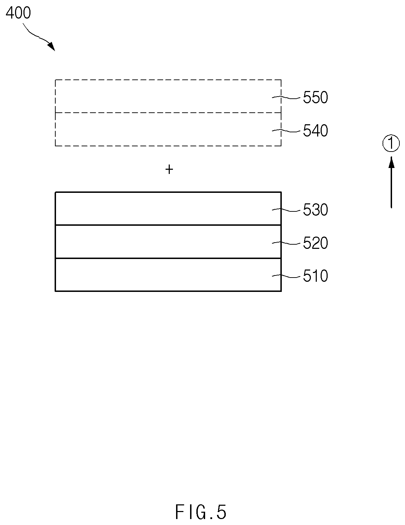

FIG. 5 illustrates a cross-section of the flexible printed circuit board according to an embodiment.

The description of the flexible printed circuit board 400 made with reference to FIG. 5 may be applied to at least one of the first to seventh flexible printed circuit boards 400-1 to 400-7 in substantially the same way.

Referring to FIG. 5, the flexible printed circuit board 400 may include a first layer 510, a second layer 520, and a third layer 530. In an embodiment, the third layer 530 may be disposed on a first surface of the second layer 520, and the first layer 510 may be disposed on a second surface of the second layer 520.

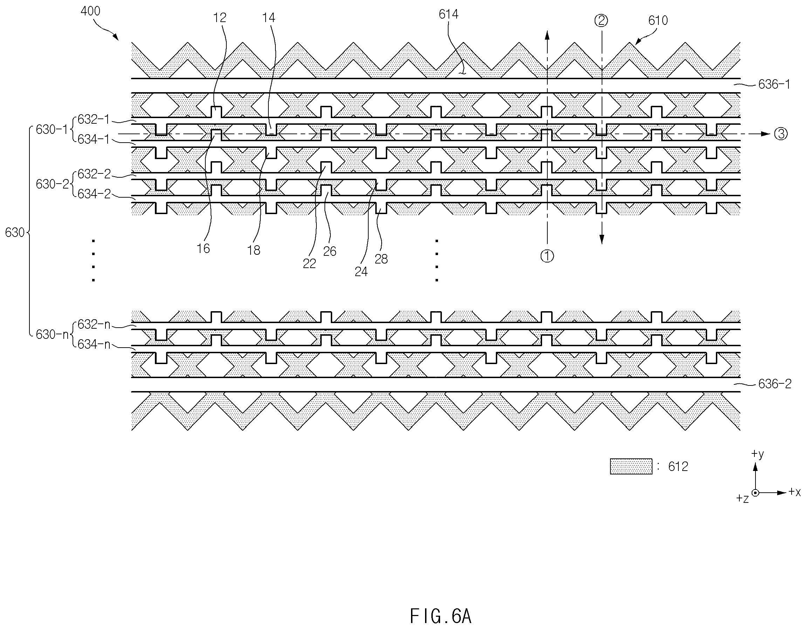

In an embodiment, the first layer 510 may include a mesh ground (e.g., a mesh ground of FIG. 6A) formed of a conductive material (e.g., copper) (however, the disclosure is not limited thereto), and the mesh ground may be operated as a ground for a transmission line (e.g., differential lines 630 of FIG. 6A) of the flexible printed circuit board 400. In an embodiment, the mesh ground of the first layer 510 may include a conductive pattern (e.g., a conductive pattern 612 of FIG. 6A) in a form of a mesh, and openings (e.g., openings 614 of FIG. 6A) defined by the conductive pattern. In an embodiment, the first layer 510 may not include flat plate-shaped ground. The flat plate-shaped ground may not include the conductive pattern and the openings defined by the conductive pattern. Because the flexible printed circuit board 400 according to an embodiment includes the mesh ground, the flexibility of the flexible printed circuit board 400 may be enhanced.

In an embodiment, the second layer 520 may be disposed on the first layer 510 (e.g., direction ①). In an embodiment, the second layer 520 may be formed of a non-conductive material (e.g., a resin). In an embodiment, the second layer 520 may include a dielectric material having a specific permittivity. In an embodiment, the second layer 520 may include a flexible material (e.g., polyimide) such that the flexible printed circuit board 400 is bent.

In an embodiment, the third layer 530 may be disposed on the second layer 520 (e.g., direction ①). In an embodiment, the third layer 530 may include transmission lines. In an embodiment, the transmission lines of the third layer 530 may be formed of a conductive material (e.g., copper) (but, the disclosure is not limited thereto). In an embodiment, the third layer 530 may include only the transmission lines, and in this case, the transmission lines may be exposed to the air. In another embodiment, the third layer 530 may include the transmission lines and a dielectric material that surrounds the transmission lines.

In another embodiment, the flexible printed circuit board 400 may further include a fourth layer 540 and a fifth layer 550. The fourth layer 540 may be disposed on the third layer (e.g., direction ①), and the fifth layer 550 may be disposed on the fourth layer 540 (e.g., direction ①). The description of the second layer 520 may be applied to the fourth layer 540, except for the location, at which the flexible printed circuit board 400 is disposed, in the substantially the same, similar, or corresponding manner. For example, the fourth layer 540 may include a dielectric material having a specific permittivity. The description of the first layer 510 may be applied to the fifth layer 550, except for the location, at which the flexible printed circuit board 400 is disposed, in the substantially the same, similar, or corresponding manner. For example, the fifth layer 550 may include a mesh ground (e.g., the second mesh ground) including a conductive pattern having a mesh shape.

FIG. 6A is a plan view of the flexible printed circuit board according to an embodiment.

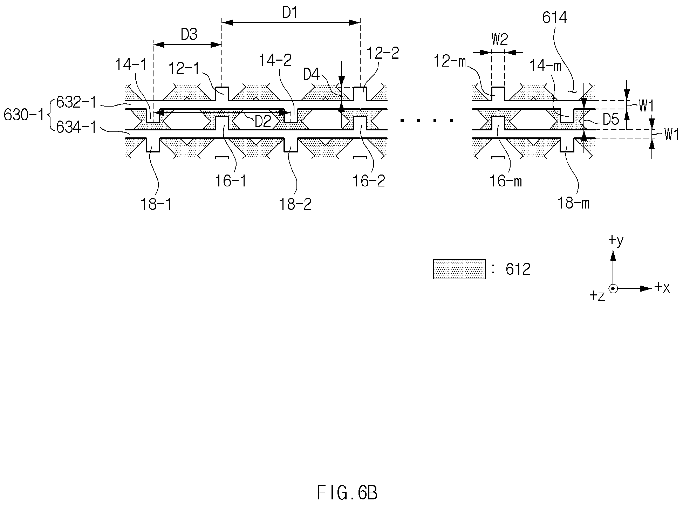

FIG. 6B illustrates a first differential line according to an embodiment.

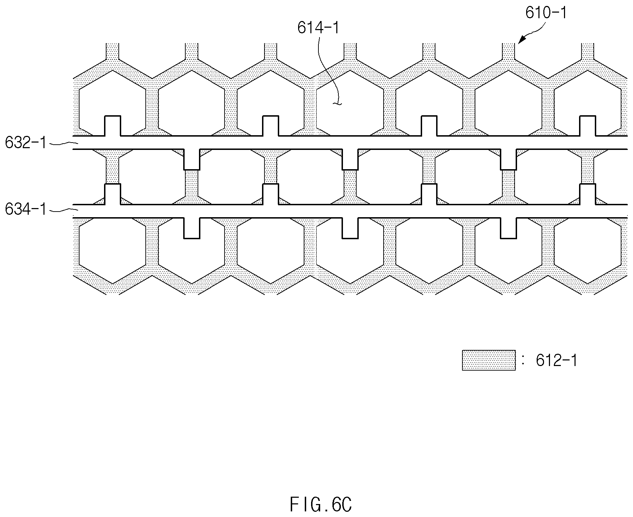

In FIG. 6B, illustration of the non-conductive layer (e.g., the second layer 520 of FIG. 5) interposed between a mesh ground 610 and the differential lines 630 is omitted. FIG. 6C is a plan view of the flexible printed circuit board, which illustrates a mesh ground according to another embodiment.

In FIGS. 6A and 6C, illustration of the non-conductive layer (e.g., the second layer 520 of FIG. 5) interposed between the mesh ground 610 and the differential lines 630 is omitted.

Referring to FIG. 6A, the flexible printed circuit board 400 according to an embodiment may include the mesh ground 610 and the differential lines 630.

In an embodiment, the mesh ground 610 may include the conductive pattern 612. In an embodiment, the mesh ground 610 may have the openings 614 defined by the conductive pattern 612. In an embodiment, a design of the conductive pattern 612 of the mesh ground 610 may be variously modified. For example, FIG. 6A illustrates the conductive pattern 612 that defines the openings 614 having a diamond shape, but the conductive pattern 612 may be formed such that the openings have a circular shape, four-sided shape (e.g., a square, a rectangular shape, a parallelogram shape, and/or a trapezoidal shape) other than a diamond shape, and/or a hexagonal shape. For example, referring to FIG. 6C, a conductive pattern 612-1 of a mesh ground 610-1 may be formed such that openings 614-1 have a hexagonal shape.

In an embodiment, the mesh ground 610 may be included in the first layer (e.g., the first layer 510 of FIG. 5) of the flexible printed circuit board 400. In an embodiment, the mesh ground 610 may define at least a portion of the first layer (e.g., the first layer 510 of FIG. 5) of the flexible printed circuit board 400.

In an embodiment, the differential lines 630 may include first to n-th differential lines 630-1 to 630-n (n is a natural number of 2 or more). In an embodiment, each of the differential lines 630 may include a pair of transmission lines. For example, the first differential line 630-1 may include a first transmission line 632-1 and a second transmission line 634-1, which are substantially parallel to each other. In an embodiment, a first signal may be applied to the first transmission line 632-1 of the first differential line 630-1, and a second signal corresponding to the first signal may be applied to the second transmission line 634-1. For example, a first signal and a second signal in a differential mode, in which they have the same amplitude and opposite phases, may be applied to the first transmission line 632-1 and the second transmission line 634-1, respectively. For example, a first signal and a second signal in a common mode, in which they have the same amplitude and the same phase, may be applied to the first transmission line 632-1 and the second transmission line 634-1, respectively.

In an embodiment, the differential lines 630 may be spaced apart from each other, and may be substantially parallel to each other. In an embodiment, the differential lines 630 may extend substantially in parallel to each other. For example, the first differential line 630-1 and the second differential line 630-2 may be spaced apart from each other, and may be substantially parallel to each other. For example, the first differential line 630-1 and the second differential line 630-2 may extend substantially in parallel to each other. In an embodiment, the differential lines 630 may overlap the conductive pattern 612 of the mesh ground 610 when the flexible printed circuit board 400 is viewed from a top (e.g., viewed in the z axis direction).

The flexible printed circuit board 400 according to an embodiment may further include guard traces 636. In an embodiment, the guard trace 636 may include a first guard trace 636-1 and a second guard trace 636-2.

In an embodiment, the guard traces 636 may be disposed on opposite sides of the differential lines 630. In an embodiment, the guard traces 636 may be disposed to, among the differential lines 630, differential lines that are located on the outermost side. For example, the first guard trace 636-1 may be disposed to be adjacent to the first differential line 630-1, and the second guard trace 636-2 may be disposed to be adjacent to the n-th differential lines 630-n. In an embodiment, the guard traces 636 may extend substantially in parallel to the differential lines 630 on an outside of the differential lines 630. In an embodiment, the guard traces 636 may be formed of a conductive material (e.g., copper) (but, the disclosure is not limited thereto). In an embodiment, the guard traces 636 may overlap the mesh ground 610 when the flexible printed circuit board 400 is viewed from a top (e.g., viewed in the z axis direction). In an embodiment, the guard traces 636 may be electrically connected to the mesh ground 610, through conductive vias that pass through the dielectric material (not illustrated) (e.g., the second layer 520 of FIG. 5) between the mesh ground 610 and the guard traces 636. In another embodiment, the conductive vias may be omitted.

In an embodiment, the differential lines 630 may be included in the third layer (e.g., the third layer 530 of FIG. 5) of the flexible printed circuit board 400. In an embodiment, the differential lines 630 may define at least a portion of the third layer (e.g., the third layer 530 of FIG. 5) of the flexible printed circuit board 400.

In an embodiment, each of the transmission lines of the differential lines 630 may include stubs that protrude from the transmission line. For example, the first transmission line 632-1 may include first stubs 12 and second stubs 14, and the second transmission line 634-1 may include third stubs 16 and fourth stubs 18. For example, a third transmission line 632-2 may include fifth stubs 22 and sixth stubs 24, and a fourth transmission line 634-2 may include seventh stubs 26 and eighth stubs 28.

In an embodiment, the first stubs 12 may protrude from the first transmission line 632-1 in a first direction (e.g., the +y axis direction). In an embodiment, the first stubs 12 may extend from the first transmission line 632-1 in a direction that becomes farther away from the second transmission line 634-1. In an embodiment, the first stubs 12 may extend from the first transmission line 632-1 toward the first guard trace 636-1 that is adjacent to the first transmission line 632-1. In an embodiment, the first stubs 12 of the first differential line 630-1 may protrude (extend) from the first transmission line 632-1 in a direction that becomes farther away from the second differential line 630-2 that is adjacent to the first differential line 630-1. In an embodiment, the first stubs 12 may be substantially perpendicular to a lengthwise direction (e.g., the x axis direction) of the first transmission line 632-1. For example, the first stubs 12 may extend in a direction that is substantially perpendicular to a lengthwise direction (e.g., the x axis direction) of the first transmission line 632-1.

In an embodiment, the second stubs 14 may protrude from the first transmission line 632-1 in a second direction (e.g., the -y axis direction) that is an opposite direction to the first direction. For example, the second stubs 14 may protrude from the first transmission line 632-1 between the first transmission line 632-1 and the second transmission line 634-1. In an embodiment, the second stubs 14 may protrude (or extend) from the first transmission line 632-1 toward the differential line that is adjacent to the first transmission line 632-1. For example, the second stubs 14 may protrude (or extend) from the first transmission line 632-1 toward the second differential line 630-2 that is adjacent to the first transmission line 632-1. In an embodiment, the second stubs 14 may protrude from the first transmission line 632-1 toward the second transmission line 634-1. In an embodiment, the second stubs 14 may be substantially perpendicular to a lengthwise direction (e.g., the x axis direction) of the first transmission line 632-1. For example, the second stubs 14 may extend in a direction that is substantially perpendicular to a lengthwise direction (e.g., the x axis direction) of the first transmission line 632-1.

In an embodiment, the third stubs 16 may protrude from the second transmission line 634-1 in a first direction (e.g., the +y axis direction). For example, the third stubs 16 may protrude from the second transmission line 634-1 between the first transmission line 632-1 and the second transmission line 634-1. In an embodiment, the third stubs 16 may extend from the second transmission line 634-1 toward the first transmission line 632-1. In an embodiment, the third stubs 16 may extend from the second transmission line 634-1 in a direction that becomes farther away from the second transmission line 634-1. For example, the third stubs 16 may protrude (or extend) from the second transmission line 634-1 in a direction that becomes farther away the second differential line 630-2 that is closest to the second transmission line 634-1. In an embodiment, the third stubs 16 may extend from the second transmission line 634-1 in a direction that becomes farther away from the second differential line 630-2. In an embodiment, the first stubs 12 may be substantially perpendicular to a lengthwise direction (e.g., the x axis direction) of the second transmission line 634-1. For example, the first stubs 12 may extend in a direction that is substantially perpendicular to a lengthwise direction (e.g., the x axis direction) of the second transmission line 634-1.

In an embodiment, the fourth stubs 18 may protrude from the second transmission line 634-1 in a second direction (e.g., the -y axis direction) that is an opposite direction to the first direction. In an embodiment, the fourth stubs 18 may extend from the second transmission line 634-1 in a direction that becomes farther away from the first transmission line 632-1. In an embodiment, the fourth stubs 18 may protrude (or extend) from the second transmission line 634-1 toward the differential line that is closest to the second transmission line 634-1. For example, the fourth stubs 18 may protrude (or extend) from the second transmission line 634-1 toward the second differential line 630-2 that is closest to the second transmission line 634-1. In an embodiment, the fourth stubs 18 may protrude from the second transmission line 634-1 toward the second differential line 630-2. In an embodiment, the fourth stubs 18 may extend from the second transmission line 634-1 toward the third transmission line 632-2. In an embodiment, the fourth stubs 18 may be substantially perpendicular to a lengthwise direction (e.g., the x axis direction) of the second transmission line 634-1. For example, the first stubs 12 may extend in a direction that is substantially perpendicular to a lengthwise direction (e.g., the x axis direction) of the second transmission line 634-1.

In an embodiment, the fifth stubs 22 may protrude from the third transmission line 632-2 in the first direction. In an embodiment, the fifth stubs 22 may protrude (or extend) from the third transmission line 632-2 toward the differential line that is closest to the third transmission line 632-2. For example, the fifth stubs 22 may protrude (or extend) from the third transmission line 632-2 toward the first differential line 630-1 that is closest to the third transmission line 632-2. In an embodiment, the fifth stubs 22 may protrude from the third transmission line 632-2 toward the first differential line 630-1. In an embodiment, the fifth stubs 22 may protrude from the second transmission line 634-1. In an embodiment, the fifth stubs 22 may extend from the third transmission line 632-2 in a direction that becomes farther away from the fourth transmission line 634-2. In an embodiment, the fifth stubs 22 may be substantially perpendicular to a lengthwise direction (e.g., the x axis direction) of the third transmission line 632-2. For example, the fifth stubs 22 may extend in a direction that is substantially perpendicular to a lengthwise direction (e.g., the x axis direction) of the third transmission line 632-2. In an embodiment, the fifth stubs 22 may be spaced apart from each other.

In an embodiment, the sixth stubs 24 may protrude from the third transmission line 632-2 in the second direction. In an embodiment, the sixth stubs 24 may protrude from the third transmission line 632-2 toward the fourth transmission line 634-2. For example, the sixth stubs 24 may protrude from the third transmission line 632-2 between the third transmission line 632-2 and the fourth transmission line 634-2. In an example, the sixth stubs 24 may protrude (or extend) from the third transmission line 632-2 in a direction that becomes farther away from the differential line (e.g., the first differential line 630-1) that is closest to the third transmission line 632-2. In an embodiment, the sixth stubs 24 may extend from the third transmission line 632-2 in a direction that becomes farther away from the first differential line 630-1. In an embodiment, the sixth stubs 24 may be substantially perpendicular to a lengthwise direction (e.g., the x axis direction) of the third transmission line 632-2. For example, the sixth stubs 24 may extend in a direction that is substantially perpendicular to a lengthwise direction (e.g., the x axis direction) of the third transmission line 632-2.

In an embodiment, the seventh stubs 26 may protrude from the fourth transmission line 634-2 in the first direction. In an example, the seventh stubs 26 may protrude (or extend) from the fourth transmission line 634-2 in a direction that becomes farther away from the differential line (e.g., the third differential line 630-3 when n is 3 or more) that is closest to the fourth transmission line 634-2. In an embodiment, the seventh stubs 26 may protrude from the fourth transmission line 634-2 toward the first differential line 630-1. In an embodiment, the seventh stubs 26 may protrude from the fourth transmission line 634-2 toward the third transmission line 632-2. As an example, the seventh stubs 26 may protrude (or extend) from the fourth transmission line 634-2 between the third transmission line 632-2 and the fourth transmission line 634-2. In an embodiment, the seventh stubs 26 may be substantially perpendicular to a lengthwise direction (e.g., the x axis direction) of the fourth transmission line 634-2. For example, the seventh stubs 26 may extend in a direction that is substantially perpendicular to a lengthwise direction (e.g., the x axis direction) of the fourth transmission line 634-2.

In an embodiment, the eighth stubs 28 may protrude from the fourth transmission line 634-2 in the second direction. In an example, the eighth stubs 28 may protrude (or extend) from the fourth transmission line 634-2 toward the differential line (e.g., the third differential line 630-3 when n is 3 or more) that is closest to the fourth transmission line 634-2. In an embodiment, the eighth stubs 28 may extend from the fourth transmission line 634-2 in a direction that becomes farther away from the first differential line 630-1. In an embodiment, the eighth stubs 28 may extend from the fourth transmission line 634-2 toward the second guard trace 636-2. In an embodiment, the eighth stubs 28 may be substantially perpendicular to a lengthwise direction (e.g., the x axis direction) of the fourth transmission line 634-2. For example, the eighth stubs 28 may extend in a direction that is substantially perpendicular to a lengthwise direction (e.g., the x axis direction) of the fourth transmission line 634-2.

In an embodiment, the first stubs 12, the third stubs 16, the fifth stubs 22, and the seventh stubs 26 may be at least aligned in the first direction (e.g., direction ①). In an embodiment, when the flexible printed circuit board 400 is viewed from a lateral side (e.g., when viewed in the y axis direction), the first stubs 12, the third stubs 16, the fifth stubs 22, and the seventh stubs 26 may at least partially overlap each other.

In an embodiment, the second stubs 14, the fourth stubs 18, the sixth stubs 24, and the eighth stubs 28 may be at least aligned in the second direction (e.g., direction ②). In an embodiment, when the flexible printed circuit board 400 is viewed from a lateral side (e.g., when viewed in the y axis direction), the second stubs 14, the fourth stubs 18, the sixth stubs 24, and the eighth stubs 28 may at least partially overlap each other.

In an embodiment, when viewed in a lengthwise direction (e.g., direction ③) of the first differential line 630-1, the second stubs 14 and the third stubs 16 may at least partially overlap each other. However, the disclosure is not limited thereto.

In an embodiment, when viewed in a lengthwise direction (e.g., a direction that is parallel to direction ③) of the second differential line 630-2, the sixth stubs 24 and the seventh stubs 26 may at least partially overlap each other. However, the disclosure is not limited thereto.

In an example, a distance between the first transmission line 632-1 and the second transmission line 634-1 may be smaller than a distance between the second transmission line 634-1 and the third transmission line 632-2. However, the disclosure is not limited thereto.

In an embodiment, the pair of transmission lines that constitute each of the differential lines 630 may have substantially the same shape. For example, the first transmission line 632-1 and the second transmission line 634-1 may have substantially the same shape. In a comparative example, when the second stubs 14 and/or the third stubs 16 of the first differential line 630-1 are omitted, the first transmission line 632-1 and the second transmission line 634-1 may have shapes that are not the same. In this case, a quality of a differential signal transmitted through the first transmission line 632-1 and the second transmission line 634-1 may be degraded. In an embodiment, because the first transmission line 632-1 and the second transmission line 634-1 have substantially the same shape, a discontinuity of differential signals applied to the first transmission line 632-1 and the second transmission line 634-1 may be eliminated, and a quality of the differential signal provided through the first differential line 630-1 may be enhanced.

FIG. 6A illustrates the first differential line 630-1, the second differential line 630-2, and the n-th differential line 630-n, but the differential lines 630 are not limited by the illustration of FIG. 6A to include at least three differential lines. For example, the differential lines 630 may include only the first differential line 630-1 and the second differential line 630-2, and as another example, the differential lines 630 may include first to fourth differential lines 630-1 to 630-4. That is, the differential lines 630 may include at least two differential lines (e.g., first to n-th differential lines 630-1 to 630-n (n is a natural number of 2 or more)).

Referring to FIG. 6B, the first transmission line 632-1 of the first differential line 630-1 according to an embodiment may include first stubs 12-1 to 12-m and second stubs 14-1 to 14-m. The second transmission line 634-1 according to an embodiment may include third stubs 16-1 to 16-m and fourth stubs 18-1 to 18-m. In an embodiment, the first stubs 12-1 to 12-m, the second stubs 14-1 to 14-m, the third stubs 16-1 to 16-m, and the fourth stubs may correspond to the first stubs 12, the second stubs 14, the third stubs 16, and the fourth stubs 18 of FIG. 6A, respectively.

In an embodiment, the first transmission line 632-1 may extend along a lengthwise direction (e.g., the +x axis direction) of a first width W1. In an embodiment, the second transmission line 634-1 may extend along a lengthwise direction (e.g., the +x axis direction) of the first width W1. In an embodiment, the first width W1, for example, may be 35 $\mu$m to 120 $\mu$m, but the disclosure is not limited thereto. In an example, the first transmission line 632-1 and the second transmission line 634-1 may be substantially parallel to each other. In an example, the first transmission line 632-1 and the second transmission line 634-1 may be spaced apart from each other by a fifth distance D5. In an embodiment, the fifth distance D5, for example, may be one to three times of the first width W1. For example, when the first width W1 is 35 $\mu$m, the fifth distance D5 may be 35 $\mu$m to 105 $\mu$m. However, the disclosure is not limited thereto.

Although not illustrated, the second transmission line 634-1 and the third transmission line 632-2 (of FIG. 6A) may be spaced apart from each other by a sixth distance D6. The sixth distance D6 may be substantially the same as the fifth distance D5, but the disclosure is not limited thereto. For example, the sixth distance may be larger than the fifth distance.

In an embodiment, the first stubs 12-1 to 12-m (m is a natural number of 2 or more) may be formed in the first transmission line 632-1. In an embodiment, the first stubs 12-1 to 12-m may be disposed at a first distance D1 along a lengthwise direction (e.g., the +x direction) of the first transmission line 632-1. In an embodiment, the first distance D1, for example, may be one to five times of the first width W1, but the disclosure is not limited thereto. For example, when the first width W1 is 35 $\mu$m, the first distance D1 may be 35 $\mu$m to 175 $\mu$m, but the disclosure is not limited thereto and the first distance D1 may be 175 $\mu$m or more. In an embodiment, the first stubs 12-1 to 12-m may have a second width W2 and a fourth length D4. In an embodiment, the second width W2, for example, may be 35 $\mu$m to 120 $\mu$m, but the disclosure is not limited thereto. In an embodiment, the second width W2 may be substantially the same as the first width W1, and in another embodiment, the second width W2 may be different from the first width W1. In an embodiment, the fourth length D4 may be determined such that the stubs are prevented from being short-circuited with the transmission line. For example, the fourth length D4 may be smaller than the fifth distance D5. For example, the fourth length D4 may be about 0.1 to about 0.9 times of the fifth distance D5, but the disclosure is not limited thereto. For example, when the fifth distance D5 is 70 $\mu$m, the fourth length D4 may be 7 $\mu$m to 63 $\mu$m.

In an embodiment, each of the first stubs 12-1 to 12-m may protrude between adjacent second stubs 14-1 to 14-m. For example, the first stub 12-1 may protrude between the adjacent second stubs 14-1 and 14-2.

In an embodiment, each of the first stubs 12-1 to 12-m may be spaced apart from the adjacent second stubs 14-1 to 14-m by a third distance D3. For example, the first stub 12-1 may be spaced apart from the second stub 14-1 by the third distance D3. In an embodiment, when the first stubs 12-1 to 12-m are located at dead centers of the adjacent second stubs 14-1 to 14-m, the third distance D3 may be a half of a second distance D2 with respect to a lengthwise direction (e.g., the X axis direction) of the first transmission line 632-1.

In an embodiment, the second stubs 14-1 to 14-m may be formed in the first transmission line 632-1. In an embodiment, the second stubs 14-1 to 14-m may be disposed at the second distance D2 along a lengthwise direction of the first transmission line 632-1. In an embodiment, the second distance D2 may be substantially the same as the first distance D1, but the disclosure is not limited thereto.

In an embodiment, each of the second stubs 14-1 to 14-m may protrude toward the second transmission line 634-1, between the adjacent first stubs 12-1 to 12-m. For example, the second stub 14-2 may protrude toward the second transmission line 634-1, between the adjacent first stubs 12-1 and 12-2.

In an embodiment, each of the second stubs 14-1 to 14-m may protrude from the first transmission line 632-1, between adjacent third stubs 16-1 to 16-m. For example, the second stub 14-2 may extend from the first transmission line 632-1, between the adjacent third stubs 16-1 and 16-2, which are adjacent to the second stub 14-2.

In an embodiment, the second stubs 14-2 to 14-m may have the second width W2 and the fourth length D4 that are substantially the same as those of the first stubs 12-1 and 12-m.

In an embodiment, the third stubs 16-1 to 16-m may be formed in the second transmission line 634-1. In an embodiment, the third stubs 16-1 to 16-m may be disposed at the same distance as the first distance D1 along a lengthwise direction of the second transmission line 634-1.

In an embodiment, each of the third stubs 16-1 to 16-m may protrude toward the first transmission line 632-1, between the adjacent fourth stubs 18-1 to 18-m. For example, the third stub 16-1 may protrude toward the first transmission line 632-1, between the adjacent fourth stubs 18-1 and 18-2.

In an embodiment, each of the third stubs 16-1 to 16-m may protrude from the second transmission line 634-1, between the adjacent fourth stubs 18-1 to 18-m. For example, the second stub 16-2 may extend from the second transmission line 634-1, between the adjacent second stubs 14-1 and 14-2, which are adjacent to the second stub 16-2.

In an embodiment, the second stubs 16-3 to 16-m may have the second width W2 and the fourth length D4 that are substantially the same as those of the first stubs 12-1 and 12-m.

In an embodiment, the fourth stubs 18-1 to 18-m may be disposed at the same distance as the second distance D2 along a lengthwise direction of the second transmission line 634-1.

In an embodiment, the fourth stubs 18-4 to 18-m may have the second width W2 and the fourth length D4 that are substantially the same as those of the first stubs 12-1 and 12-m.

In an embodiment, each of the fourth stubs 18-1 to 18-m may protrude facing away from the first transmission line 632-1, between the adjacent third stubs 16-1 to 16-m. For example, the fourth stub 18-2 may protrude facing away from the first transmission line 632-1, between the adjacent third stubs 16-1 and 16-2. Although not illustrated, each of the fourth stubs 18-1 to 18-m may extend between the adjacent fifth stubs (e.g., the fifth stubs 22 of FIG. 5A).

In an embodiment, when the flexible printed circuit board 400 is viewed from a top (e.g., when viewed in the z axis direction), the first stubs 12-1 to 12-m and the fourth stubs 18-1 to 18-m may at least partially overlap the openings 614 formed in the mesh ground 610.

The description of the first differential line 630-1, which has been made with reference to FIG. 6B, also may be applied to the second to n-th differential lines 630-1 to 630-n of FIG. 6A in substantially the same, similar, or corresponding manner.

The descriptions of the first stubs 12-1 to 12-m, the second stubs 14-1 to 14-m, the third stubs 16-1 to 16-m, and the fourth stubs 18-1 to 18-m of the first differential line 630-1, which have been made with reference to FIG. 6B, also may be applied to the stubs (e.g., the fifth stubs 22, the sixth stubs 24, the seventh stubs 26, and the eighth stubs 28 of FIG. 6A, which are included in the second differential line 630-2) included in the second to n-th differential lines 630-1 to 630-n of FIG. 6A in substantially the same, similar, or corresponding manner.

A flexible printed circuit board (e.g., the flexible printed circuit board 400 of FIG. 5) according to an embodiment may include a first differential line (e.g., the first differential line 630-1 of FIG. 6A) a first dielectric layer (e.g., the second layer 520 of FIG. 5), a first transmission line (e.g., the first transmission line 632-1 of FIG. 6A), and a second transmission line (e.g., the second transmission line 634-1 of FIG. 6A) that is substantially parallel to the first transmission line, and a first mesh ground (e.g., the mesh ground 610 of FIG. 6A) disposed on a second surface of the first dielectric layer, and the first transmission line may include first stubs (e.g., the first stubs 12 of FIG. 6A) disposed at a first distance (e.g., the first distance D1 of FIG. 6B) along a lengthwise direction of the first transmission line, and protruding in a first direction that is substantially perpendicular to the lengthwise direction of the first transmission line, and second stubs (e.g., the second stubs 14 of FIG. 6A) disposed at a second distance (e.g., the second distance D2 of FIG. 6B) along the lengthwise direction of the first transmission line, and protruding in a second direction that is opposite to the first direction - each of the second stubs protrudes toward the second transmission line between the adjacent first stubs, and the second transmission line may include third stubs (e.g., the third stubs 16 of FIG. 6A) disposed at the first distance along a lengthwise direction of the second transmission line and protruding in the second direction - each of the third stubs are at least partially aligned with the corresponding first stub in the first direction, and fourth stubs (e.g., the fourth stubs 18 of FIG. 6A) disposed at the second distance along a lengthwise direction of the second transmission line and protruding in the second direction - each of the fourth stubs are at least partially aligned with the corresponding second stubs in the second direction.

In an embodiment, the first mesh ground may include a conductive pattern (e.g., the conductive pattern 612 of FIG. 6A), a plurality of openings (e.g., the openings 614 of FIG. 6A) surrounded by the conductive pattern may be formed in the first mesh ground, and the first stubs and the fourth stubs may at least partially overlap the plurality of openings when the first surface is viewed from a top.

In an embodiment, the plurality of openings may have at least one of a diamond shape, a rectangular shape, a hexagonal shape, or a circular shape.

In an embodiment, the first transmission line and the second transmission line may have substantially the same shape.

In an embodiment, a width of the first transmission line may be 35 $\mu$m to 125 $\mu$m.

In an embodiment, at least one of the first stubs or the second stubs may have a width that is substantially the same as a width of the first transmission line.

In an embodiment, the first distance may be 35 $\mu$m to 125 $\mu$m.

In an embodiment, the first distance and the second distance may be substantially the same.

In an embodiment, each of the second stubs may be spaced apart from the adjacent first stubs at a third distance (e.g., the third distance D3 of FIG. 6B), and the third distance may be a half of the first distance or the second distance with respect to the lengthwise direction of the first transmission line.

In an embodiment, the first transmission line and the second transmission line may include copper.

An electronic device (e.g., the electronic device 401 of FIG. 4) according to an embodiment may include a printed circuit board (e.g., the first printed circuit board 441 of FIG. 4), a camera module (e.g., the first camera module 405 of FIG. 4 or the second camera module 412 of FIG. 4) including at least one camera, and at least one processor (e.g., the processor 920 of FIG. 9) disposed in the printed circuit board, the flexible printed circuit board may be connected to the camera module and the printed circuit board, and at least one processor may be electrically connected to the camera module through an electrical path provided by the printed circuit board and the flexible printed circuit board to communicate with the camera module.

In an embodiment, the second stubs of the first transmission line may protrude toward the second transmission line, and the third stubs of the second transmission line may protrude toward the first transmission line.

The electronic device according to an embodiment may include a second dielectric layer (e.g., the fourth layer 540 of FIG. 5) and a second mesh ground (e.g., the fifth layer 550 of FIG. 5) disposed in the second dielectric layer, and the first transmission line and the second transmission line may be located between the first dielectric layer and the second dielectric layer.

In an embodiment, the electronic device may include a second differential line (e.g., the second differential line 630-2 of FIG. 6A) disposed on the first surface of the first dielectric layer and spaced apart from the first differential line, the second differential line may include a third transmission line (e.g., the third transmission line 632-2 of FIG. 6A) that is substantially parallel to the second transmission line, and a fourth transmission line (e.g., the fourth transmission line 634-2 of FIG. 6A) that is substantially parallel to the third transmission line, the third transmission line may include fifth stubs (e.g., the fifth stubs 22 of FIG. 6A) located between the second transmission line and the fourth transmission line and protruding toward the second transmission line, and sixth stubs (e.g., the sixth stubs 24 of FIG. 6A) protruding toward the fourth transmission line, and the fourth transmission line may include seventh stubs (e.g., the seventh stubs 26 of FIG. 6A) protruding toward the third transmission line, and eighth stubs (e.g., the eighth stubs 28 of FIG. 6A) protruding in an opposite direction to a direction, in which the seventh stubs protrude.

In an embodiment, the fifth stubs may be at least partially aligned with the third stubs in the first direction, the sixth stubs may be at least partially aligned with the fourth stubs in the second direction, the seventh stubs may be at least partially aligned with the fifth stubs in the first direction, and the eighth stubs may be at least partially aligned with the sixth stubs in the second direction.

In an embodiment, the fifth stubs and the eighth stubs may at least partially overlap the plurality of openings when the flexible printed circuit board is viewed from a top.

An electronic device (e.g., the electronic device 401 of FIG. 4) according to an embodiment may include a plurality of flexible printed circuit boards (e.g., the flexible printed circuit board 400 of FIG. 4), a first printed circuit board (e.g., the first printed circuit board 441 of FIG. 4), a camera module (e.g., the first camera module 405 or the second camera module 412 of FIG. 4) electrically connected to the first printed circuit board through, among the plurality of flexible printed circuit boards, a first flexible printed circuit board (e.g., the third flexible printed circuit board 400-3 or the fourth flexible printed circuit board 400-4 of FIG. 4), and a second printed circuit board (e.g., the second printed circuit board 442) electrically connected to the first printed circuit board through, among the plurality of flexible printed circuit boards, a second flexible printed circuit board (e.g., the first flexible printed circuit board 400-1 of FIG. 4), each of the plurality of flexible printed circuit boards may include a first dielectric layer (e.g., the second layer 520 of FIG. 5), a first differential line (e.g., the first differential line 630-1 of FIG. 6A) disposed on a first surface of the first dielectric layer, and including a first transmission line (e.g., the first transmission line 632-1 of FIG. 6A) and a second transmission line (e.g., the second transmission line 634-1 of FIG. 6A) that is substantially parallel to the first transmission line, and a mesh ground (e.g., the mesh ground 610 of FIG. 6A) disposed on a second surface of the first dielectric layer, the first transmission line may include first stubs (e.g., the first stubs 12 of FIG. 6A) disposed at a first distance (e.g., the first distance D1 of FIG. 6B) along a lengthwise direction of the first transmission line, and protruding in a first direction that is substantially perpendicular to a lengthwise direction of the first transmission line, and second stubs (e.g., the second stubs 14 of FIG. 6A) disposed at a second distance (e.g., the second distance D2 of FIG. 6B) along the lengthwise direction of the first transmission line, and protruding in a second direction that is opposite to the first direction - each of the second stubs protrudes toward the second transmission line between the adjacent first stubs, and the second transmission line may include third stubs (e.g., the third stubs 16 of FIG. 6A) disposed at the first distance along a lengthwise direction of the second transmission line and protruding in the first direction - each of the third stubs are at least partially aligned with the corresponding first stub in the first direction, and fourth stubs (e.g., the fourth stubs 18 of FIG. 6A) disposed at the first distance along a lengthwise direction of the second transmission line and protruding in the second direction - each of the fourth stubs are at least partially aligned with the corresponding second stub in the second direction.

In an embodiment, the mesh ground may include a conductive pattern (e.g., the conductive pattern 612 of FIG. 6A), a plurality of openings (e.g., the openings 614 of FIG. 6A) surrounded by the conductive pattern may be formed in the mesh ground, and the first stubs and the fourth stubs may at least partially overlap the plurality of openings when the first surface is viewed from a top.

In an embodiment, the first transmission line and the second transmission line may have substantially the same shape.

In an embodiment, the second stubs may be spaced apart from the first stubs at a third distance, the first distance may be substantially the same as the second distance, and the third distance may be a half of the first interval with respect to the lengthwise direction of the first transmission line.

The electronic device according to an embodiment may include a second differential line (e.g., the second differential line 630-2 of FIG. 6A) disposed on the first surface of the first dielectric layer and spaced apart from the first differential line, the second differential line may include a third transmission line (e.g., the third transmission line 632-2 of FIG. 6A) that is substantially parallel to the second transmission line, and a fourth transmission line (e.g., the fourth transmission line 634-2 of FIG. 6A) that is substantially parallel to the third transmission line, and the third transmission line may be located between the second transmission line and the fourth transmission line, and may include fifth stubs (e.g., the fifth stubs 22 of FIG. 6A) protruding toward the second transmission line, and being at least partially aligned with the third stubs in the first direction, and sixth stubs (e.g., the sixth stubs 24 of FIG. 6A) protruding toward the fourth transmission line and being at least partially aligned with the fourth stubs in the second direction, and the fourth transmission line may include seventh stubs (e.g., the seventh stubs 26 of FIG. 6A) protruding toward the third transmission line and being at least partially aligned with the fifth stubs in the first direction, and eighth stubs (e.g., the eighth stubs 28 of FIG. 6A) protruding in an opposite direction to a direction, in which the seventh stubs protrude, and being at least partially aligned with the sixth stubs in the second direction.

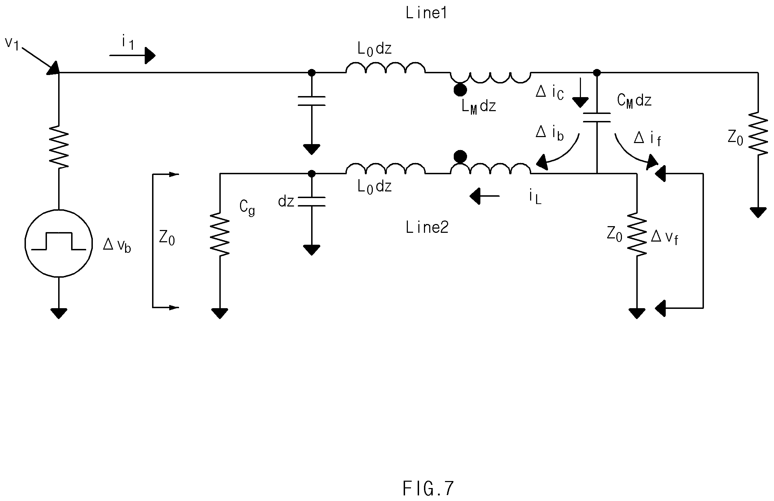

FIG. 7 is an equivalent circuit diagram of the first differential line and the second differential line of FIG. 6A.

Referring to FIG. 7, line 1 may be referenced as the first differential line 630-1 of FIG. 6A, and line 2 may be referenced as the second differential line 630-2 of FIG. 6A.

A signal may be applied to line 1. When the signal is applied to line 1, an electromagnetic coupling phenomenon may occur between line 1 and line 2 that are adjacent to each other. Accordingly, a cross-talk that is a phenomenon, in which energy is transited from the signal applied to line 1 to line 2, may be caused. A line that causes a cross-talk when being applied like line 1 may be referred to as an aggressor line, and a line that is influenced by the caused cross-talk like line 2 may be referred to as a victim line.

The cross-talk phenomenon may be caused by capacitive coupling and inductive coupling of line 1 and line 2 that are adjacent to each other. When a signal is applied to line 1, a voltage may be generated in line 2 due to the capacitive coupling $C_M$ of line 1 and line 2, and thus currents $i_b$ and $i_f$ that flows in opposite directions of line 2 may be generated. Furthermore, through the inductive coupling $L_M$ of line 1 and line 2, a current $i_L$ that flows a transmission driver of line 2 may be generated.

The cross-talk from line 1 to line 2 may be classified into a far-end cross-talk (FEXT) that is caused in the same direction as a flow direction of an applied signal, that is, by which the signal applied to line 1 is delivered to a receiver of line 2, and a near-end cross-talk (NEXT) that is caused in an opposite direction to the flow direction of the signal, that is, by which the signal applied to line 1 is delivered to a transmitter of line 2.

The near-end cross-talk is generated from a transition time point of the signal to a time point, at which noise

**EP 4 216 681 B1**

reflected from a terminal end reaches the transmitter again, and thus it may appear for a time period of twice of a propagation delay. The near-end cross-talk is propagated in an opposite direction to a flow direction of an aggressor signal from a generation time point thereof, and thus it may appear as a constant value.

The far-end cross-talk is propagated in the same direction as and at the same speed as those of the aggressor signal, and thus it may be generated for a transition time period of the signal, from a time point, at which the aggressor signal reaches the terminal end. The far-end cross-talk accumulates energy coupled as the signal flows, and thus, a value thereof may be larger than that of the near-end cross-talk.

The far-end cross-talk and the near-end cross-talk may badly influence signal integrity of the signal. A magnitude of the far-end cross-talk may be larger than that of the near-end cross-talk, and thus there may be an error in logical switching whereby a possibility of causing a malfunction may become higher.

Equation 1 as follows is an equation that represents a voltage due to the far-end cross-talk coupled from the aggressor line (e.g., line 1) to the victim line (e.g., line 2).

[Equation 1]

$$v_{Fext} = \frac{1}{2}\left(\frac{C_m}{C_T} - \frac{L_m}{L_s}\right)\frac{l}{v_p}\frac{dv_1}{dt} = \frac{1}{2}\left(\frac{C_m}{C_T} - \frac{L_m}{L_s}\right)\frac{l}{v_p}\frac{v}{t_r}$$

In Equation above, $V_{Fext}$ is a voltage of the far-end cross-talk, $v_p$ is a propagation speed of the signal, "1" is a length of the coupled line, $t_r$ is a rising time, v means a voltage applied, $C_m$ is a mutual capacitance per unit length, $C_s$ is a self-capacitance per unit length, $C_T$ is a sum off $C_s$ and $C_m$, $L_m$ is a mutual inductance per unit length, and $L_s$ is a self-inductance per unit length.

Referring to Equation 1, when a ratio ($C_m/C_T$) of the capacitances and a ratio ($L_m/L_s$) of the inductances are the same, the far-end cross-talk ($V_{Fext}$) may be eliminated ($V_{Fext} = 0$). As an absolute of a difference between the ratio ($C_m/C_T$) of the capacitances and the ratio ($L_m/L_s$) of the inductances becomes closer to 0, the far-end cross-talk ($V_{Fext}$) may decrease.

Because the differential lines 630 according to an embodiment include the stubs, the mutual capacitance $C_m$ between the adjacent differential lines may increase. For example, referring to FIG. 6A, because the first differential line 630-1 and the second differential line 630-2 that are adjacent to each other include the fourth stubs 18 and the fifth stubs 22, respectively, a distance between the first differential line 630-1 and the second differential line 630-2 may become closer than when they have no stub, and thus an area, in which the first differential line 630-1 and the second differential line 630-2 face each othr may increase. Accordingly, the mutual capacitance $C_m$ between the first differential line 630-1 and the second differential line 630-2 may increase.

In an embodiment, because the differential lines 630 including the stubs are disposed on the mesh ground 610, the self-capacitance $C_s$ may not increase or an increase thereof may be smaller than that of the mutual capacitance $C_m$. For example, with reference to FIG. 6A, because the first stubs 12 and the fourth stubs 18 of the first differential line 630-1 may at least partially overlap the openings 614 of the mesh ground 610, the self-capacitance $C_s$ between the first differential line 630-1 and the mesh ground 610 may be maintained or an increase thereof may be smaller than that of the mutual capacitance $C_m$.

In an embodiment, because the mutual capacitance $C_m$ of the differential lines 630 may increase and the increase of the self-capacitance $C_s$ is smaller than that of the mutual capacitance $C_m$, a capacitance ratio ($C_m/(C_s + C_m)$) of the differential lines 630 may increase.

In an embodiment, even when the differential lines 630 have stubs, an inductance ratio ($L/L_s$) may be maintained. This is because the stubs of the differential lines extend in a direction that is perpendicular to a flow direction of the signal provided to the differential lines 630.

In an embodiment, because the capacitance ratio ($C_m/(C_s + C_m)$) of the differential lines 630 including the stubs increase and the inductance ratio ($L_m/L_s$) is maintained, the far-end cross-talk that may be caused in the differential lines 630 may decrease.

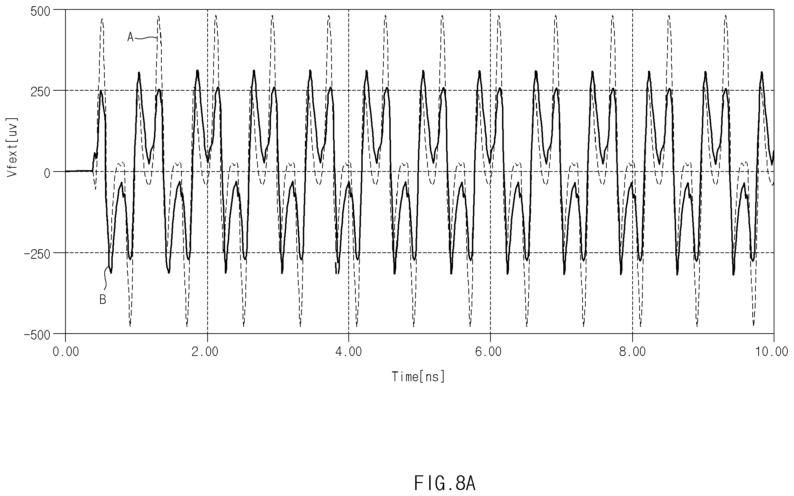

FIG. 8A is a graph depicting voltages of far-end cross-talks of the differential line according a comparative example and a differential line according to an embodiment.

Graph "A" of FIG. 8A, which is indicated by a dotted line, depicts a voltage $V_{fext}$ of a near-end cross-talk of a differential line that includes no stub according to the comparative example, and graph "B" indicated by a solid line depicts a voltage $V_{fext}$ of the far-end cross-talk of the differential lines 630 according to an embodiment.

Referring to FIG. 8A, in the case (graph "B") of the differential lines 630 according to an embodiment, the voltage $V_{fext}$ of the far-end cross-talk may be decreased by about 35% as compared with the differential lines (graph "A") of the comparative example.

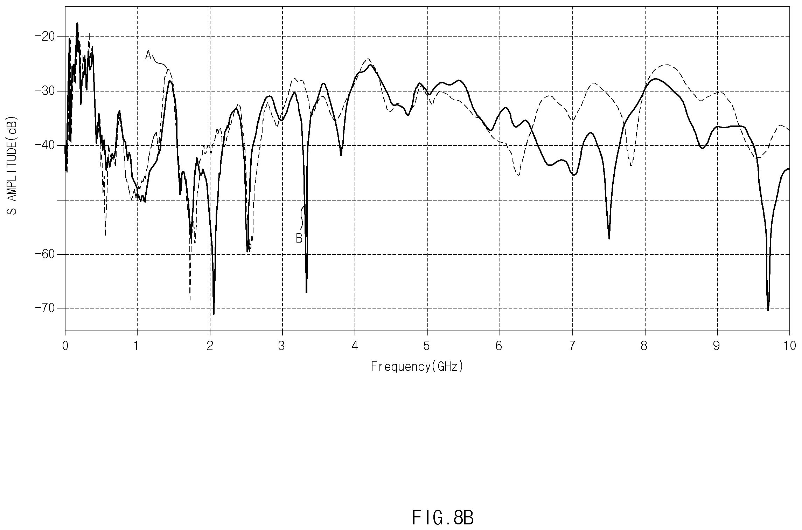

FIG. 8B is a graph depicting "S" parameters of a flexible printed circuit board according to a comparative example and the flexible printed circuit board according to an embodiment.

The "S" parameter of FIG. 8B, for example, may be a value S41 that represents a ratio of an input voltage of line 1 of FIG. 7 to an output voltage of line 2.

Graph "A" of FIG. 8B depicts an "S" parameter of the flexible printed circuit board including transmission lines that include no stub according to the comparative example, and graph "B" depicts an "S" parameter of the flexible printed circuit board 400 including the differential lines 630 according to an embodiment.

Referring to FIG. 8B, in the case (graph "B") of the flexible printed circuit board 400 according to an embodiment, an "S" parameter performance may be improved as compared with the case (graph "A") of the flexible printed circuit board of the comparative example. For example, in a frequency range of 1 GHz to 3 GHz, the "S" parameter performance may be improved by about 5 dB to 10 dB. The frequency range of 1 GHz to 3 GHz, for example, may be an operation frequency of an MIPI clock (CLK) lane.

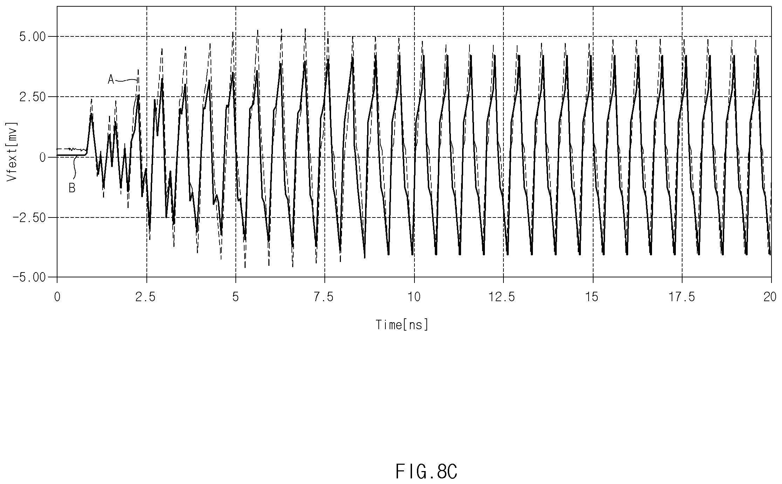

FIG. 8C illustrates voltages of the flexible printed circuit board according to the comparative example and the flexible printed circuit board according to an embodiment.

The graph of FIG. 8C may be a graph that depicts a result of a circuit simulation based on the "S" parameter value measured in FIG. 8B.

Graph "A" of FIG. 8C depicts a voltage of the far-end cross-talk of the flexible printed circuit board including transmission lines that include no stub according to the comparative example, and graph "B" depicts a voltage of the far-end cross-talk of the flexible printed circuit board 400 including the according to an embodiment.

Referring to FIG. 8C, in the case (graph "B") of the flexible printed circuit board 400 according to an embodiment, the voltage $V_{fext}$ of the far-end cross-talk may be decreased as compared with the case (graph "A") of the flexible printed circuit board of the comparative example.

FIG. 9 is a block diagram illustrating an electronic device 901 in a network environment 900 according to various embodiments.

Referring to FIG. 9, the electronic device 901 in the network environment 900 may communicate with an electronic device 902 via a first network 998 (e.g., a short-range wireless communication network), or an electronic device 904 or a server 908 via a second network 999 (e.g., a long-range wireless communication network). According to an embodiment, the electronic device 901 may communicate with the electronic device 904 via the server 908. According to an embodiment, the electronic device 901 may include a processor 920, memory 930, an input module 950, a sound output module 955, a display module 960, an audio module 970, a sensor module 976, an interface 977, a connecting terminal 978, a haptic module 979, a camera module 980, a power management module 988, a battery 989, a communication module 990, a subscriber identification module (SIM) 996, or an antenna module 997. In some embodiments, at least one of the components (e.g., the connecting terminal 978) may be omitted from the electronic device 901, or one or more other components may be added in the electronic device 901. In some embodiments, some of the components (e.g., the sensor module 976, the camera module 980, or the antenna module 997) may be implemented as a single component (e.g., the display module 960).

The processor 920 may execute, for example, software (e.g., a program 940) to control at least one other component (e.g., a hardware or software component) of the electronic device 901 coupled with the processor 920, and may perform various data processing or computation. According to one embodiment, as at least part of the data processing or computation, the processor 920 may store a command or data received from another component (e.g., the sensor module 976 or the communication module 990) in volatile memory 932, process the command or the data stored in the volatile memory 932, and store resulting data in non-volatile memory 934. According to an embodiment, the processor 920 may include a main processor 921 (e.g., a central processing unit (CPU) or an application processor (AP)), or an auxiliary processor 923 (e.g., a graphics processing unit (GPU), a neural processing unit (NPU), an image signal processor (ISP), a sensor hub processor, or a communication processor (CP)) that is operable independently from, or in conjunction with, the main processor 921. For example, when the electronic device 901 includes the main processor 921 and the auxiliary processor 923, the auxiliary processor 923 may be adapted to consume less power than the main processor 921, or to be specific to a specified function. The auxiliary processor 923 may be implemented as separate from, or as part of the main processor 921.

The auxiliary processor 923 may control at least some of functions or states related to at least one component (e.g., the display module 960, the sensor module 976, or the communication module 990) among the components of the electronic device 901, instead of the main processor 921 while the main processor 921 is in an inactive (e.g., sleep) state, or together with the main processor 921 while the main processor 921 is in an active state (e.g., executing an application). According to an embodiment, the auxiliary processor 923 (e.g., an image signal processor or a communication processor) may be implemented as part of another component (e.g., the camera module 980 or the communication module 990) functionally related to the auxiliary processor 923. According to an embodiment, the auxiliary processor 923 (e.g., the neural processing unit) may include a hardware structure specified for artificial intelligence model processing. An artificial intelligence model may be generated by machine learning. Such learning may be performed, e.g., by the electronic device 901 where the artificial intelligence is performed or via a separate server (e.g., the server 908). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 930 may store various data used by at least one component (e.g., the processor 920 or the sensor module 976) of the electronic device 901. The various data may include, for example, software (e.g., the program 940) and input data or output data for a command related thereto. The memory 930 may include the volatile memory 932 or the non-volatile memory 934.

The program 940 may be stored in the memory 930 as software, and may include, for example, an operating system (OS) 942, middleware 944, or an application 946.

The input module 950 may receive a command or data to be used by another component (e.g., the processor 920) of the electronic device 901, from the outside (e.g., a user) of the electronic device 901. The input module 950 may include, for example, a microphone, a mouse, a keyboard, a key (e.g., a button), or a digital pen (e.g., a stylus pen).

The sound output module 955 may output sound signals to the outside of the electronic device 901. The sound output module 955 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 960 may visually provide information to the outside (e.g., a user) of the electronic device 901. The display module 960 may include, for example, a display, a hologram device, or a projector and control circuitry to control a corresponding one of the display, hologram device, and projector. According to an embodiment, the display module 960 may include a touch sensor adapted to detect a touch, or a pressure sensor adapted to measure the intensity of force incurred by the touch.

The audio module 970 may convert a sound into an electrical signal and vice versa. According to an embodiment, the audio module 970 may obtain the sound via the input module 950, or output the sound via the sound output module 955 or a headphone of an external electronic device (e.g., an electronic device 902) directly (e.g., wiredly) or wirelessly coupled with the electronic device 901.

The sensor module 976 may detect an operational state (e.g., power or temperature) of the electronic device 901 or an environmental state (e.g., a state of a user) external to the electronic device 901, and then generate an electrical signal or data value corresponding to the detected state. According to an embodiment, the sensor module 976 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 977 may support one or more specified protocols to be used for the electronic device 901 to be coupled with the external electronic device (e.g., the electronic device 902) directly (e.g., wiredly) or wirelessly. According to an embodiment, the interface 977 may include, for example, a high definition multimedia interface (HDMI), a universal serial bus (USB) interface, a secure digital (SD) card interface, or an audio interface.

A connecting terminal 978 may include a connector via which the electronic device 901 may be physically connected with the external electronic device (e.g., the electronic device 902). According to an embodiment, the connecting terminal 978 may include, for example, a HDMI connector, a USB connector, a SD card connector, or an audio connector (e.g., a headphone connector).

The haptic module 979 may convert an electrical signal into a mechanical stimulus (e.g., a vibration or a movement) or electrical stimulus which may be recognized by a user via his tactile sensation or kinesthetic sensation. According to an embodiment, the haptic module 979 may include, for example, a motor, a piezoelectric element, or an electric stimulator.

The camera module 980 may capture a still image or moving images. According to an embodiment, the camera module 980 may include one or more lenses, image sensors, image signal processors, or flashes.

The power management module 988 may manage power supplied to the electronic device 901. According to one embodiment, the power management module 988 may be implemented as at least part of, for example, a power management integrated circuit (PMIC).

The battery 989 may supply power to at least one component of the electronic device 901. According to an embodiment, the battery 989 may include, for example, a primary cell which is not rechargeable, a secondary cell which is rechargeable, or a fuel cell.

The communication module 990 may support establishing a direct (e.g., wired) communication channel or a wireless communication channel between the electronic device 901 and the external electronic device (e.g., the electronic device 902, the electronic device 904, or the server 908) and performing communication via the established communication channel. The communication module 990 may include one or more communication processors that are operable independently from the processor 920 (e.g., the application processor (AP)) and supports a direct (e.g., wired) communication or a wireless communication. According to an embodiment, the communication module 990 may include a wireless communication module 992 (e.g., a cellular communication module, a short-range wireless communication module, or a global navigation satellite system (GNSS) communication module) or a wired communication module 994 (e.g., a local area network (LAN) communication module or a power line communication (PLC) module). A corresponding one of these communication modules may communicate with the external electronic device via the first network 998 (e.g., a short-range communication network, such as Bluetooth™, wireless-fidelity (Wi-Fi) direct, or infrared data association (IrDA)) or the second network 999 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 992 may identify and authenticate the electronic device 901 in a communication network, such as the first network 998 or the second network 999, using subscriber information (e.g., international mobile subscriber identity (IMSI)) stored in the subscriber identification module 996.

The wireless communication module 992 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 992 may support a high-frequency band (e.g., the mmWave band) to achieve, e.g., a high data transmission rate. The wireless communication module 992 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 992 may support various requirements specified in the electronic device 901, an external electronic device (e.g., the electronic device 904 ), or a network system (e.g., the second network 999). According to an embodiment, the wireless communication module 992 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 997 may transmit or receive a signal or power to or from the outside (e.g., the external electronic device) of the electronic device 901. According to an embodiment, the antenna module 997 may include an antenna including a radiating element composed of a conductive material or a conductive pattern formed in or on a substrate (e.g., a printed circuit board (PCB)). According to an embodiment, the antenna module 997 may include a plurality of antennas (e.g., array antennas). In such a case, at least one antenna appropriate for a communication scheme used in the communication network, such as the first network 998 or the second network 999, may be selected, for example, by the communication module 990 (e.g., the wireless communication module 992) from the plurality of antennas. The signal or the power may then be transmitted or received between the communication module 990 and the external electronic device via the selected at least one antenna. According to an embodiment, another component (e.g., a radio frequency integrated circuit (RFIC)) other than the radiating element may be additionally formed as part of the antenna module 997.

According to various embodiments, the antenna module 997 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 901 and the external electronic device 904 via the server 908 coupled with the second network 999. Each of the electronic devices 902 or 904 may be a device of a same type as, or a different type, from the electronic device 901. According to an embodiment, all or some of operations to be executed at the electronic device 901 may be executed at one or more of the external electronic devices 902, 904, or 908. For example, if the electronic device 901 should perform a function or a service automatically, or in response to a request from a user or another device, the electronic device 901, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 901. The electronic device 901 may provide the outcome, with or without further processing of the outcome, as at least part of a reply to the request. To that end, a cloud computing, distributed computing, mobile edge computing (MEC), or client-server computing technology may be used, for example. The electronic device 901 may provide ultra low-latency services using, e.g., distributed computing or mobile edge computing. In another embodiment, the external electronic device 904 may include an internet-of-things (IoT) device. The server 908 may be an intelligent server using machine learning and/or a neural network. According to an embodiment, the external electronic device 904 or the server 908 may be included in the second network 999. The electronic device 901 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 540) including one or more instructions that are stored in a storage medium (e.g., internal memory 536 or external memory 538) that is readable by a machine (e.g., the electronic device 501). For example, a processor (e.g., the processor 520) of the machine (e.g., the electronic device 501) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium, where the term "non-transitory" refers to the storage medium being a tangible device, and does not include a signal (e.g., an electromagnetic wave), but this term does not differentiate between data being semi-permanently stored in the storage medium and the data being temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

According to the situation, an expression "adapted to or configured to," if used in this disclosure, may be used interchangeably with the expression "suitable for", "having the capacity to", "adapted to", "made to", "capable of", or "designed to" in hardware or software, for example. The expression "a device configured to" may mean that the device is "capable of" operating together with another device or other components. A "processor set to (or configured to) perform A, B, and C" may mean a dedicated processor (e.g., an embedded processor) for performing corresponding operations or a generic-purpose processor (e.g., a CPU or an AP) that performs corresponding operations by executing one or more programs stored in a memory device (e.g., memory), for example.

As used in connection with various embodiments of the disclosure, the term "module" may include a unit implemented in hardware, software, or firmware, and may interchangeably be used with other terms, e.g., "logic," "logic block," "part," or "circuitry". A module may be a single integral component, or a minimum unit or part thereof, adapted to perform one or more functions. The "module" may be implemented mechanically or electronically and may include an application-specific integrated circuit (ASIC) chip, field-programmable gate arrays (FPGAs), or a programmable-logic device for performing some operations, for example, which are known or will be developed.

At least a part of an apparatus (e.g., modules or functions thereof) or a method (e.g., operations) in various embodiments may be implemented by instructions stored in computer-readable storage media (e.g., memory) in the form of a program module. The instructions, when executed by a processor (e.g., a processor), may cause the processor to perform functions corresponding to the instructions. The computer-readable storage media may include a hard disk, a floppy disk, a magnetic media (e.g., a magnetic tape), an optical media (e.g., CD-ROM, DVD, magneto-optical media (e.g., a floptical disk)), an embedded memory, or the like. The instructions may include a code made by a compiler or a code executable by an interpreter.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

1. An electronic device including a flexible printed circuit board (400), wherein the flexible printed circuit board (400) includes:

    a first dielectric layer;
    a first differential line (630-1) disposed on a first surface of the first dielectric layer, and including a first transmission line (632-1) and a second transmission line (634-1) that is parallel to the first transmission line (632-1); and
    a first mesh ground (610) disposed on a second surface of the first dielectric layer,
    wherein the first transmission line (632-1) includes:

       first stubs (12) disposed at a first distance along a lengthwise direction of the first transmission line (632-1), and protruding in a first direction that is perpendicular to the lengthwise direction of the first transmission line (632-1); and

second stubs (14) disposed at a second distance along the lengthwise direction of the first transmission line (632-1) and protruding in a second direction that is opposite to the first direction, wherein each of the second stubs (14) protrudes toward the second transmission line (634-1) between the first stubs (12) adjacent to each other,

wherein the second transmission line (634-1) includes:

third stubs (16) disposed at the first distance along the lengthwise direction of the second transmission line (634-1) and protruding in the first direction, wherein each of the third stubs (16) is at least partially aligned with the corresponding first stub (12) in the first direction; and

fourth stubs (18) disposed at the second distance along the lengthwise direction of the second transmission line (634-1) and protruding in the second direction, wherein each of the fourth stubs (18) is at least partially aligned with the corresponding second stub (14) in the second direction,

wherein the first mesh ground (610) includes a conductive pattern (612), and a plurality of openings (614) surrounded by the conductive pattern (612),

wherein a plurality of openings (614) surrounded by the conductive pattern (612) is formed in the first mesh ground (610), and

wherein the first stubs (12) and the fourth stubs (18) at least partially overlap the plurality of openings (614) when the first surface is viewed from a top.

2. The electronic device of claim 1, wherein the plurality of openings (614) have at least one of a diamond shape, a rectangular shape, a hexagonal shape, or a circular shape.

3. The electronic device of claim 1, wherein the first transmission line (632-1) and the second transmission line (634-1) have the same shape.

4. The electronic device of claim 1, wherein a width of the first transmission line (632-1) is 35 $\mu$m to 125 $\mu$m.

5. The electronic device of claim 1, wherein at least one of the first stubs (12) or the second stubs (14) has a width that is the same as a width of the first transmission line (632-1).

6. The electronic device of claim 1, wherein the first distance is 35 $\mu$m to 175 $\mu$m.

7. The electronic device of claim 1, wherein the first distance is the same as the second distance.

8. The electronic device of claim 1, wherein each of the second stubs (14) is spaced apart from ones of the first stubs (12), which are adjacent thereto, at a third distance, and
wherein the third distance is a half of the first distance or the second distance with respect to the lengthwise direction of the first transmission line (632-1).

9. The electronic device of claim 1, comprising:

a printed circuit board;
a camera module including at least one camera; and
at least one processor disposed in the printed circuit board,
wherein the flexible printed circuit board (400) is connected to the camera module and the printed circuit board, and
wherein the at least one processor is electrically connected to the camera module through an electrical path provided by the printed circuit board and the flexible printed circuit board (400) to communicate with the camera module.

10. The electronic device of claim 1, wherein the second stubs (14) of the first transmission line (632-1) protrude toward the second transmission line (634-1), and
wherein the third stubs (16) of the second transmission line (634-1) protrude toward the first transmission line (632-1).

11. The electronic device of claim 1, wherein the flexible printed circuit board (400) includes a second dielectric layer and a second mesh ground disposed in the second dielectric layer, and
wherein the first transmission line (632-1) and the second transmission line (634-1) are located between the first dielectric layer and the second dielectric layer.

12. The electronic device of claim 1, wherein a printed circuit board includes a second differential line (630-2) disposed on the first surface of the first dielectric layer and spaced apart from the first differential line (630-1), wherein the second differential line (630-2) includes:

a third transmission line (632-2) being parallel to the second transmission line (634-1); and
a fourth transmission line (634-2) spaced apart from the third transmission line (632-2) and being parallel to the third transmission line (632-2), wherein the third transmission line (632-2) is located between the second transmission line (634-1) and the fourth transmission line (634-2),
wherein the third transmission line (632-2) includes fifth stubs (22) protruding toward the second transmission line (634-1) and sixth stubs (24) protruding toward the fourth transmission line (634-2), and
wherein the fourth transmission line (634-2) includes seventh stubs (26) protruding toward the third transmission line (632-2) and eighth stubs (28) protruding in an opposite direction to a direction, in which the seventh stubs (26) protrude.

13. The electronic device of claim 12, wherein the fifth stubs (22) are at least partially aligned with the third stubs (16) in the first direction,

wherein the sixth stubs (24) are at least partially aligned with the fourth stubs (18) in the second direction,
wherein the seventh stubs (26) are at least partially aligned with the fifth stubs (22) in the first direction, and
wherein the eighth stubs (28) are at least partially aligned with the sixth stubs (24) in the second direction.

14. The electronic device of claim 12, wherein the fifth stubs (22) and the eighth stubs (28) at least partially overlap the plurality of openings (614) when the flexible printed circuit board (400) is viewed from a top.

**Patentansprüche**

1. Elektronische Vorrichtung mit einer flexiblen Leiterplatte (400), wobei die flexible Leiterplatte (400) Folgendes umfasst:

eine erste dielektrische Schicht;
eine erste Differenzleitung (630-1), die auf einer ersten Oberfläche der ersten dielektrischen Schicht angeordnet ist und eine erste Übertragungsleitung (632-1) und eine zweite Übertragungsleitung (634-1) umfasst, die parallel zur ersten Übertragungsleitung (632-1) verläuft; und
eine erste Maschenmasse (610), die auf einer zweiten Oberfläche der ersten dielektrischen Schicht angeordnet ist,
wobei die erste Übertragungsleitung (632-1) Folgendes umfasst:

erste Stichleitungen (12), die in einem ersten Abstand entlang einer Längsrichtung der ersten Übertragungsleitung (632-1) angeordnet sind und in eine erste Richtung vorstehen, die senkrecht zur Längsrichtung der ersten Übertragungsleitung (632-1) ist; und
zweite Stichleitungen (14), die in einem zweiten Abstand entlang der Längsrichtung der ersten Übertragungsleitung (632-1) angeordnet sind und in eine zweite Richtung vorstehen, die der ersten Richtung entgegengesetzt ist, wobei jede der zweiten Stichleitungen (14) zwischen den ersten Stichleitungen (12), die aneinander angrenzen, in Richtung der zweiten Übertragungsleitung (634-1) vorsteht,
wobei die zweite Übertragungsleitung (634-1) Folgendes umfasst:

dritte Stichleitungen (16), die in dem ersten Abstand entlang der Längsrichtung der zweiten Übertragungsleitung (634-1) angeordnet sind und in die ersten Richtung vorstehen, wobei jede der dritten Stichleitungen (16) zumindest teilweise mit der entsprechenden ersten Stichleitung (12) in der ersten Richtung ausgerichtet ist; und
vierte Stichleitungen (18), die in dem zweiten Abstand entlang der Längsrichtung der zweiten Übertragungsleitung (634-1) angeordnet sind und in die zweite Richtung vorstehen, wobei jede der vierten Stichleitungen (18) zumindest teilweise mit der entsprechenden zweiten Stichleitung (14) in der zweiten Richtung ausgerichtet ist,
wobei die erste Maschenmasse (610) ein leitfähiges Muster (612) und eine Vielzahl von Öffnungen (614) umfasst, die von dem leitfähigen Muster (612) umgeben sind,
wobei eine Vielzahl von Öffnungen (614), die von dem leitfähigen Muster (612) umgeben sind, in der ersten Maschenmasse (610) ausgebildet ist, und
wobei die ersten Stichleitungen (12) und die vierten Stichleitungen (18) die Vielzahl von Öffnungen (614) zumindest teilweise überlappen, wenn die erste Oberfläche von oben betrachtet wird.

2. Elektronische Vorrichtung nach Anspruch 1, wobei die mehreren Öffnungen (614) mindestens eine von einer Rautenform, einer rechteckigen Form, einer sechseckigen Form und einer kreisförmigen Form aufweisen.

3. Elektronische Vorrichtung nach Anspruch 1, wobei die erste Übertragungsleitung (632-1) und die zweite Übertragungsleitung (634-1) die gleiche Form aufweisen.

4. Elektronische Vorrichtung nach Anspruch 1, wobei eine Breite der ersten Übertragungsleitung (632-1) 35 μm bis 125 μm beträgt.

5. Elektronische Vorrichtung nach Anspruch 1, wobei mindestens eine der ersten Stichleitungen (12) oder der zweiten Stichleitungen (14) eine Breite aufweist, die einer Breite der ersten Übertragungsleitung (632-1) entspricht.

6. Elektronische Vorrichtung nach Anspruch 1, wobei der erste Abstand 35 μm bis 175 μm beträgt.

7. Elektronische Vorrichtung nach Anspruch 1, wobei der erste Abstand dem zweiten Abstand entspricht.

8. Elektronische Vorrichtung nach Anspruch 1, wobei jede der zweiten Stichleitungen (14) von denjenigen der ersten Stichleitungen (12), an die sie angrenzt, in einem dritten Abstand beabstandet ist, und
wobei der dritte Abstand die Hälfte des ersten Abstands oder des zweiten Abstands in Bezug auf die Längsrichtung der ersten Übertragungsleitung (632-1) beträgt.

9. Elektronische Vorrichtung nach Anspruch 1, umfassend:

eine Leiterplatte;
ein Kameramodul mit mindestens einer Kamera; und
mindestens einen in der Leiterplatte angeordneten Prozessor,
wobei die flexible Leiterplatte (400) mit dem Kameramodul und der Leiterplatte verbunden ist, und
wobei der mindestens eine Prozessor über einen von der Leiterplatte und der flexiblen Leiterplatte (400) bereitgestellten elektrischen Pfad elektrisch mit dem Kameramodul verbunden ist, um mit dem Kameramodul zu kommunizieren.

10. Elektronische Vorrichtung nach Anspruch 1, wobei die zweiten Stichleitungen (14) der ersten Übertragungsleitung (632-1) in Richtung der zweiten Übertragungsleitung (634-1) vorstehen, und
wobei die dritten Stichleitungen (16) der zweiten Übertragungsleitung (634-1) in Richtung der ersten Übertragungsleitung (632-1) vorstehen.

11. Elektronische Vorrichtung nach Anspruch 1, wobei die flexible Leiterplatte (400) eine zweite dielektrische Schicht und eine zweite Maschenmasse umfasst, die in der zweiten dielektrischen Schicht angeordnet ist, und
wobei sich die erste Übertragungsleitung (632-1) und die zweite Übertragungsleitung (634-1) zwischen der ersten dielektrischen Schicht und der zweiten dielektrischen Schicht befinden.

12. Elektronische Vorrichtung nach Anspruch 1, wobei eine Leiterplatte eine zweite Differenzleitung (630-2) umfasst, die auf der ersten Oberfläche der ersten dielektrischen Schicht angeordnet und von der ersten Differenzleitung (630-1) beabstandet ist,
wobei die zweite Differenzleitung (630-2) Folgendes umfasst:

eine dritte Übertragungsleitung (632-2), die parallel zur zweiten Übertragungsleitung (634-1) verläuft; und
eine vierte Übertragungsleitung (634-2), die von der dritten Übertragungsleitung (632-2) beabstandet ist und parallel zur dritten Übertragungsleitung (632-2) verläuft, wobei sich die dritte Übertragungsleitung (632-2) zwischen der zweiten Übertragungsleitung (634-1) und der vierten Übertragungsleitung (634-2) befindet,
wobei die dritte Übertragungsleitung (632-2) fünfte Stichleitungen (22), die in Richtung der zweiten Übertragungsleitung (634-1) vorstehen, und sechste Stichleitungen (24) umfasst, die in Richtung der vierten Übertragungsleitung (634-2) vorstehen, und
wobei die vierte Übertragungsleitung (634-2) siebte Stichleitungen (26), die in Richtung der dritten Übertragungsleitung (632-2) vorstehen, und achte Stichleitungen (28) umfasst, die in eine Richtung vorstehen, die entgegengesetzt zu einer Richtung ist, in die die siebten Stichleitungen (26) vorstehen.

13. Elektronische Vorrichtung nach Anspruch 12, wobei die fünften Stichleitungen (22) zumindest teilweise mit den dritten Stichleitungen (16) in der ersten Richtung ausgerichtet sind,

   wobei die sechsten Stichleitungen (24) zumindest teilweise mit den vierten Stichleitungen (18) in der zweiten Richtung ausgerichtet sind,
   wobei die siebten Stichleitungen (26) zumindest teilweise mit den fünften Stichleitungen (22) in der ersten Richtung ausgerichtet sind, und
   wobei die achten Stichleitungen (28) zumindest teilweise mit den sechsten Stichleitungen (24) in der zweiten Richtung ausgerichtet sind.

14. Elektronische Vorrichtung nach Anspruch 12, wobei die fünften Stichleitungen (22) und die achten Stichleitungen (28) die mehreren Öffnungen (614) zumindest teilweise überlappen, wenn die flexible Leiterplatte (400) von oben betrachtet wird.


**Revendications**

1. Dispositif électronique comportant une carte de circuit imprimé souple (400), dans lequel la carte de circuit imprimé souple (400) comporte :

   une première couche diélectrique ;
   une première ligne différentielle (630-1) disposée sur une première surface de la première couche diélectrique, et comportant une première ligne de transmission (632-1) et une deuxième ligne de transmission (634-1) parallèle à la première ligne de transmission (632-1) ; et
   une première masse maillée (610) disposée sur une seconde surface de la première couche diélectrique,
   dans lequel la première ligne de transmission (632-1) comporte :

      des premiers tronçons (12) disposés à une première distance le long d'une direction longitudinale de la première ligne de transmission (632-1), et faisant saillie dans une première direction perpendiculaire à la direction longitudinale de la première ligne de transmission (632-1) ; et
      des deuxièmes tronçons (14) disposés à une deuxième distance le long de la direction longitudinale de la première ligne de transmission (632-1) et faisant saillie dans une seconde direction opposée à la première direction, dans lequel chacun des deuxièmes tronçons (14) fait saillie vers la deuxième ligne de transmission (634-1) entre les premiers tronçons (12) adjacents entre eux,
      dans lequel la deuxième ligne de transmission (634-1) comporte :

         des troisièmes tronçons (16) disposés à la première distance le long de la direction longitudinale de la deuxième ligne de transmission (634-1) et faisant saillie dans la première direction, dans lequel chacun des troisièmes tronçons (16) est au moins partiellement aligné avec le premier tronçon correspondant (12) dans la première direction ; et
         des quatrièmes tronçons (18) disposés à la deuxième distance le long de la direction longitudinale de la deuxième ligne de transmission (634-1) et faisant saillie dans la seconde direction, dans lequel chacun des quatrièmes tronçons (18) est au moins partiellement aligné avec le deuxième tronçon correspondant (14) dans la seconde direction,
         dans lequel la première masse maillée (610) comporte un motif conducteur (612), et une pluralité d'ouvertures (614) entourées par le motif conducteur (612),
         dans lequel la pluralité d'ouvertures (614) entourées par le motif conducteur (612) est formée dans la première masse maillée (610), et
         dans lequel les premiers tronçons (12) et les quatrièmes tronçons (18) recouvrent au moins partiellement la pluralité d'ouvertures (614) lorsque la première surface est observée depuis le dessus.

2. Dispositif électronique selon la revendication 1, dans lequel la pluralité d'ouvertures (614) a au moins l'une parmi une forme en losange, une forme rectangulaire, une forme hexagonale, ou une forme circulaire.

3. Dispositif électronique selon la revendication 1, dans lequel la première ligne de transmission (632-1) et la deuxième ligne de transmission (634-1) ont la même forme.

4.  Dispositif électronique selon la revendication 1, dans lequel une largeur de la première ligne de transmission (632-1) est de 35 μm à 125 μm.

5.  Dispositif électronique selon la revendication 1, dans lequel au moins l'un parmi les premiers tronçons (12) ou les deuxièmes tronçons (14) a une largeur identique à une largeur de la première ligne de transmission (632-1).

6.  Dispositif électronique selon la revendication 1, dans lequel la première distance est de 35 μm à 175 μm.

7.  Dispositif électronique selon la revendication 1, dans lequel la première distance est identique à la deuxième distance.

8.  Dispositif électronique selon la revendication 1, dans lequel chacun des deuxièmes tronçons (14) est espacé des premiers tronçons (12) qui lui sont adjacents d'une troisième distance, et
    dans lequel la troisième distance est la moitié de la première distance ou de la deuxième distance par rapport à la direction longitudinale de la première ligne de transmission (632-1).

9.  Dispositif électronique selon la revendication 1, comportant :

    une carte de circuit imprimé ;
    un module de caméra comportant au moins une caméra ; et
    au moins un processeur disposé dans la carte de circuit imprimé,
    dans lequel la carte de circuit imprimé souple (400) est reliée au module de caméra et à la carte de circuit imprimé, et
    dans lequel l'au moins un processeur est électriquement connecté au module de caméra au moyen d'un chemin électrique fourni par la carte de circuit imprimé et la carte de circuit imprimé souple (400) afin de communiquer avec le module de caméra.

10. Dispositif électronique selon la revendication 1, dans lequel les deuxièmes tronçons (14) de la première ligne de transmission (632-1) font saillie vers la deuxième ligne de transmission (634-1), et
    dans lequel les troisièmes tronçons (16) de la deuxième ligne de transmission (634-1) font saillie vers la première ligne de transmission (632-1).

11. Dispositif électronique selon la revendication 1, dans lequel la carte de circuit imprimé souple (400) comporte une seconde couche diélectrique et une seconde masse maillée disposée dans la seconde couche diélectrique, et
    dans lequel la première ligne de transmission (632-1) et la deuxième ligne de transmission (634-1) sont situées entre la première couche diélectrique et la seconde couche diélectrique.

12. Dispositif électronique selon la revendication 1, dans lequel une carte de circuit imprimé comporte une deuxième ligne différentielle (630-2) disposée sur la première surface de la première couche diélectrique et espacée de la première ligne différentielle (630-1),
    dans lequel la deuxième ligne différentielle (630-2) comporte :

    une troisième ligne de transmission (632-2) parallèle à la deuxième ligne de transmission (634-1) ; et
    une quatrième ligne de transmission (634-2) espacée de la troisième ligne de transmission (632-2) et parallèle à la troisième ligne de transmission (632-2), dans lequel la troisième ligne de transmission (632-2) est située entre la deuxième ligne de transmission (634-1) et la quatrième ligne de transmission (634-2),
    dans lequel la troisième ligne de transmission (632-2) comporte des cinquièmes tronçons (22) faisant saillie vers la deuxième ligne de transmission (634-1) et des sixièmes tronçons (24) faisant saillie vers la quatrième ligne de transmission (634-2), et
    dans lequel la quatrième ligne de transmission (634-2) comporte des septièmes tronçons (26) faisant saillie vers la troisième ligne de transmission (632-2) et des huitièmes tronçons (28) faisant saillie dans une direction opposée à la direction dans laquelle les septièmes tronçons (26) font saillie.

13. Dispositif électronique selon la revendication 12, dans lequel les cinquièmes tronçons (22) sont au moins partiellement alignés avec les troisièmes tronçons (16) dans la première direction,

    dans lequel les sixièmes tronçons (24) sont au moins partiellement alignés avec les quatrièmes tronçons (18) dans la seconde direction,

dans lequel les septièmes tronçons (26) sont au moins partiellement alignés avec les cinquièmes tronçons (22) dans la première direction, et

dans lequel les huitièmes tronçons (28) sont au moins partiellement alignés avec les sixièmes tronçons (24) dans la seconde direction.

14. Dispositif électronique selon la revendication 12, dans lequel les cinquièmes tronçons (22) et les huitièmes tronçons (28) recouvrent au moins partiellement la pluralité d'ouvertures (614) lorsque la carte de circuit imprimé souple (400) est observée depuis le dessus.

FIG.1

FIG.2

FIG.3

FIG.4

400

550
540

+

①

530
520
510

FIG.5

FIG.6A

FIG.6B

FIG.6C

FIG.7

FIG.8A

FIG.8B

FIG.8C

EP 4 216 681 B1

900

ELECTRONIC DEVICE 901

MEMORY 930

VOLATILE MEMORY 932

NON-VOLATILE MEMORY 934

INTERNAL MEMORY 936

EXTERNAL MEMORY 938

INPUT MODULE 950

DISPLAY MODULE 960

SOUND OUTPUT MODULE 955

PROGRAM 940

APPLICATION 946

MIDDLEWARE 944

OPERATING SYSTEM 942

BATTERY 989

PROCESSOR 920

MAIN PROCESSOR 921

AUXILIARY PROCESSOR 923

POWER MANAGEMENT MODULE 988

COMMUNICATION MODULE 990

WIRELESS COMMUNICATION MODULE 992

WIRED COMMUNICATION MODULE 994

SUBSCRIBER IDENTIFICATION MODULE 996

ANTENNA MODULE 997

SECOND NETWORK 999

ELECTRONIC DEVICE 904

FIRST NETWORK 998

AUDIO MODULE 970

SENSOR MODULE 976

INTERFACE 977

CONNECTING TERMINAL 978

HAPTIC MODULE 979

CAMERA MODULE 980

ELECTRONIC DEVICE 902

SERVER 908

FIG.9

## REFERENCES CITED IN THE DESCRIPTION

**Patent documents cited in the description**

- US 20010010271 A1
- US 20100327989 A1